# EUROPEAN PATENT APPLICATION

(11) **EP 2 472 601 A2**
(43) Date of publication of application: **04.07.2012**
(21) Application number: 10382273.0
(22) Date of filing: 19.10.2010
(51) Int. Cl.: H01L 31/18, H01L 31/0224

(54) **Method Of Reducing Laser-Induced Damage In Forming Laser-Processed Contacts**

(71) Applicant: BP Corporation North America Inc., Houston, TX 77079 (US)
(72) Inventor: Carlson, David E., Naperville, IL 60563 (US); Zou, Lian, Naperville, IL 60563 (US); Ren, Wensheng, Naperville, IL 60563 (US); Morilla, Carmen, Naperville, IL 60563 (US)
(74) Representative: Hamer, Christopher K.

(57) **Abstract**

A method for manufacturing a photovoltaic cell comprises depositing a passivation layer and a dielectric layer, or a dielectric passivation layer, on at least one surface of a silicon semiconductor wafer; depositing a doping layer on a region of at least one of the surfaces of the wafer; depositing an electrical contact layer comprising a metal over at least the dielectric layer or the dielectric passivation layer in the region containing the doping layer; and spatially and/or temporally pulse-shaping a laser beam directed at the surface of the wafer to form localized base and/or emitter contacts with a greatly reduced amount of laser-induced damage.

## Description

### Background of the Invention

This invention relates to methods of reducing laser-induced damage in forming laser-processed contacts, and photovoltaic cells having a minimal amount of laser-induced damage.

Photovoltaic cells convert incident light into electrical energy. Photovoltaic cells having electrical contacts on the back surface are highly efficient due to the minimized obstruction on the front surface, which maximizes the amount of surface area available to capture the electrical charges generated by the incident light interacting with the cell. However, current processes for manufacturing photovoltaic cells with lasers create at least some degree of laser-induced damage in forming the laser-processed contacts. In particular, laser-induced damage limits the quality of laser-processed emitters, either laser-fired emitters or laser-doped emitters.

Carlson, U.S. Patent Application Publication 2006/0130891 ("Carlson '891"); Carlson, U.S. Patent Application Publication 2007/0137692 ("Carlson '692"); and Carlson, U.S. Patent Application Publication 2007/0295399 ("Carlson '399") each disclose back-contact photovoltaic cells.

Carlson '891 discloses a photovoltaic cell including a wafer made from a semiconductor material of a first conductivity type. The wafer includes a first, light-receiving surface, a second surface opposite the first surface on the wafer, and a diffusion length. The photovoltaic cell includes a first passivation layer positioned over the first surface of the wafer, a first electrical contact positioned over the second surface of the wafer, and a second electrical contact positioned over the second surface of the wafer and separated electrically from the first electrical contact. The photovoltaic cell includes a second passivation layer positioned over the second surface of the wafer in the region that is at least between the first electrical contact and the second surface of the wafer. The photovoltaic cell includes a layer made from a semiconductor material of a conductivity opposite the conductivity of the wafer and positioned in the region between the second passivation layer and the first electrical contact.

Carlson '692 discloses a photovoltaic cell including a wafer made from a semiconductor material of a first conductivity type, a first light-receiving surface and a second surface opposite the first surface. The photovoltaic cell includes a first passivation layer positioned over the first surface of the wafer, and a first electrical contact comprising point contacts positioned over the second surface of the wafer and having a conductivity opposite to that of the wafer. The photovoltaic cell includes a second electrical contact comprising point contacts positioned over the second surface of the wafer and separated electrically from the first electrical contact and having a conductivity the same as that of the wafer.

Carlson '399 discloses a photovoltaic cell including a wafer made from a semiconductor material of a first conductivity type. The wafer includes a first light-receiving surface and a second surface opposite the first surface. The photovoltaic cell includes a first passivation layer positioned over the first surface of the wafer, a second passivation layer positioned over the second surface of the wafer, a first electrical contact comprising point contacts positioned over the second surface of the wafer and having a conductivity opposite to that of the wafer, and a second electrical contact comprising point contacts and positioned over the second surface of the wafer and separated electrically from the first electrical contact.

The entire teachings of U.S. Patent Application Publication Nos. 2006/0130891, 2007/0137692, and 2007/0295399 are each hereby incorporated by reference in their entirety.

Laser-fired contacts are typically formed by laser firing a metal film, such as aluminum, through a dielectric passivation layer, such as SiO₂, to form a base contact to a p-type silicon wafer. The laser firing creates a crater in the aluminum and the silicon wafer. The contact sometimes exhibits a dielectric ring around the central ablated region in the silicon wafer. This dielectric ring, or "isolation ring," surrounds the contacted area and can electrically isolate the contact from the rest of the aluminum layer. The electrical contact between the alloyed material in the crater region can be made by conductive splattered material that extends across the dielectric ring. This type of contact formation generally creates laser-induced damage in the silicon during the ablation process.

Additionally, when a laser beam interacts with a wafer, the energy density is stronger near the center, which results in radial heat release, which can result in the formation of an isolation ring around the electric contact area. Isolation rings can lead to a high contact resistance. Consequently, the ratio of the effective contact area to the total laser-fired area may be relatively low, which means that some of the laser-processed area makes no contribution to the electrical contact but may lead to a local reduction in the minority carrier lifetime.

Laser beam profiles used in laser-processing, such as in laser-firing, are typically Gaussian in shape. The Gaussian shape of the laser beam profile appears to be largely responsible for the appearance of the isolation ring. Several methods have been used to attempt to reduce or eliminate the isolation ring, but these methods require an additional process step, which increases the cost and reduces throughput.

There is a need and a desire for methods of manufacturing back-contact photovoltaic cells that reduce the amount of laser-induced damage in forming the laser-processed contacts. There is also a need and a desire for photovoltaic cells having a minimal amount of laser-induced damage.

### Summary of the Invention

This invention relates to methods of manufacturing photovoltaic cells with reduced laser-induced damage in forming laser-processed contacts. These methods include spatially and/or temporally pulse-shaping the laser beam. The invention also includes photovoltaic cells having a minimal amount of laser-induced damage.

According to one embodiment, the invention includes depositing a passivation layer and a dielectric layer, or a dielectric passivation layer, on at least one of a first or second surface of a semiconductor wafer, the wafer comprising silicon; depositing a doping layer on a region of at least one of the first and second surfaces of the wafer; depositing an electrical contact layer comprising a metal over at least the dielectric layer or the dielectric passivation layer in the region containing the doping layer; and splitting a single high-energy laser beam from a laser into an array of laser beams and directing the laser beams at the surface of the wafer in the region containing the doping layer to form localized base and/or emitter contacts on at least one surface of the wafer.

According to another embodiment, the invention includes depositing a passivation layer and a dielectric layer, or a dielectric passivation layer, on at least one of a first or second surface of a semiconductor wafer, the wafer comprising silicon; depositing a doping layer on a region of at least one of the first and second surfaces of the wafer; depositing an electrical contact layer comprising a metal over at least the dielectric layer or the dielectric passivation layer in the region containing the doping layer; and directing a laser at the surface of the wafer to form localized base and/or emitter contacts on at least the first surface of the wafer in the region containing the doping layer, and controlling the laser beam power density as a function of time.

According to yet another embodiment, the invention includes depositing a passivation layer and a dielectric layer, or a dielectric passivation layer, on at least one of a first or second surface of a semiconductor wafer, the wafer comprising silicon; depositing a doping layer on a region of at least one of the first and second surfaces of the wafer; depositing an electrical contact layer comprising a metal over at least the dielectric layer or the dielectric passivation layer in the region containing the doping layer; and splitting a single high-energy laser beam from a laser into an array of laser beams and directing the laser beams at the surface of the wafer in the region containing the doping layer to form localized base and/or emitter contacts on at least the surface of the wafer, and controlling the laser beam power density as a function of time.

Additionally, certain embodiments of the invention may include using at least one optical component selected from the group consisting of diffractive optics, microlenses, spatial light modulators such as micromirror arrays or aperture stop arrays, and combinations thereof, to split the single high-energy laser beam into the array of laser beams.

Certain embodiments of the invention may also include using a line-shaped laser beam during formation of a laser-processed contact and subsequent hydrogenation or rapid thermal processing at a temperature below about 700 degrees Celsius.

Certain embodiments of the invention may also include using a tophat laser beam shaper to change a beam profile of the laser from Gaussian to uniform.

Certain embodiments of the invention may also include treating at least one surface of the wafer with localized annealing prior to directing the array of laser beams at the surface of the wafer.

Certain embodiments of the invention may also include controlling the array of laser beams to produce an array of laser-doped or laser-fired regions each having a diameter of less than about 20 microns, and/or each having a line shape with a width of less than about 20 microns and a length greater than about 40 microns.

Certain embodiments of the invention may also include the passivation layer or dielectric passivation layer on at least one of the first and second surfaces of the wafer comprising aluminum oxide.

Certain embodiments of the invention may also include controlling the laser beam power density as a function of time by either (1) heating the metal in the electrical contact material to a temperature that melts the underlying dielectric layer or dielectric passivation layer without ablating the metal, or (2) using gated continuous wave laser pulses, wherein the gated continuous wave laser pulses contain a first pulse that melts and ablates the metal in the electrical contact layer, the passivation layer or dielectric passivation layer, and the first surface of the silicon wafer, followed by a low-energy tail of relatively long duration during which no significant ablation occurs.

The steps of the invention may be carried out in various orders. For example, the deposition of the passivation layer on the wafer may precede the deposition of the doping layer, or the deposition of the doping layer on the wafer may precede the deposition of the passivation layer. Additionally, the laser beam may be directed at the wafer either before or after depositing the electrical contact layer over the dielectric passivation layer.

Certain embodiments of the invention may also include depositing the doping layer as a plurality of dots of a n+ doped silicon ink or paste to form base contacts in an n-type silicon wafer; forming a shallow emitter or induced emitter over most of the same surface of the wafer on which the n+ doped silicon ink or paste has been deposited; depositing a plurality of dots of p+ silicon ink or paste on the surface of the wafer containing the shallow or induced emitter on which the n+ silicon ink is deposited, to form localized emitter contacts to the shallow or induced emitter in the n-type silicon wafer; and forming an isolation gap at a border region of the n+ doped silicon ink upon laser firing the contacts.

In another embodiment, a shallow emitter or an induced emitter may be formed over the rear surface of the n-type silicon wafer and a plurality of dots of p+ silicon ink is deposited to form point emitter contacts to the shallow or induced emitter, a plurality of dots of a n+ doped silicon ink is used to form base contacts, and an isolation gap is formed at a border region of the n+ doped silicon ink upon laser firing the contacts. Additionally, laser ablation may be used to form the isolation gap around the base contacts.

A shallow emitter may be formed by diffusing a dopant such as boron into an n-type silicon wafer to form a p/n junction. The term "shallow emitter" is used to refer to an emitter with a relatively high sheet resistance (e.g. between 70 and 200 ohms/square). A shallow emitter can also be formed by scanning a laser beam over a surface containing the appropriated dopant source. For example, the surface of the n-type wafer could be coated with a boron-doped silicon ink or paste, and a laser beam could be scanned over the surface to melt both the doping ink or paste and the surface of the silicon resulting in the formation of a shallow emitter.

An induced emitter can be created in an n-type silicon wafer by using atomic layer deposition or PECVD to deposit aluminum oxide which contains a large negative fixed charge density (typically on the order of 10¹³ cm⁻²). This large negative fixed charge induces a mirror charge or inversion layer at the surface of the n-type wafer, which is an induced emitter. An induced emitter can also be created by using PECVD to deposit a thin undoped amorphous silicon layer and then a thin boron-doped amorphous silicon layer on the n-type silicon wafer.

According to another embodiment, the invention includes depositing both localized n+ and p+ contacts on a rear surface of the silicon wafer, and depositing at least one antireflection layer on a front surface of the silicon wafer, wherein at least one antireflection layer contains a large density of fixed charges. One or more antireflection layers may be aluminum oxide containing a large negative fixed charge. One or more of the antireflection layers may comprise thin alternating layers of aluminum oxide and silicon oxide, or thin alternating layers of aluminum oxide and titanium oxide. Additionally, shallow or induced emitters may be formed over most of the rear surface of the silicon wafer.

According to yet another embodiment, the invention includes depositing both localized n+ and p+ contacts on a rear surface of the silicon wafer, and using laser ablation to define an interdigitated finger pattern on the rear surface of the silicon wafer.

Optionally, the invention may include such steps as depositing a second electrical contact layer comprising a metal over the region that has been laser-processed, and/or annealing the photovoltaic cell after carrying out all other recited steps, and/or treating the surface of the wafer with localized annealing prior to directing the laser at the surface of the wafer.

Certain embodiments of the invention may also apply, in a broader sense, to forming an electrical contact between an electrical conducting layer and a second layer, where there is at least a third layer positioned between the electrical conducting layer and the second layer. Such embodiments may include depositing a passivation layer and a dielectric layer, or a dielectric passivation layer, on at least one surface of the third layer; depositing a doping layer on a region of at least one surface of the third layer; depositing the electrical conducting layer over at least the dielectric layer or the dielectric passivation layer in the region containing the doping layer; and splitting a single high-energy laser beam from a laser into an array of laser beams and directing the laser beams at the surface of the third layer in the region containing the doping layer to form localized base and/or emitter contacts on at least the surface of the third layer, and controlling the laser beam power density as a function of time.

A photovoltaic cell, in accordance with the invention, may include a semiconductor wafer comprising silicon, the wafer having a first surface and a second light-receiving surface opposite the first surface; a passivation layer and a dielectric layer, or a dielectric passivation layer, positioned over at least one of the first and second surfaces of the wafer; a doping layer deposited on a region of at least one of the first and second surfaces of the wafer; an electrical contact layer comprising a metal positioned over at least the dielectric layer or the dielectric passivation layer in the region containing the doping layer; and a plurality of localized base and/or emitter contacts on at least one surface of the wafer in the region containing the doping layer.

### Brief Description of the Drawings

The accompanying drawings illustrate embodiments of the invention and, together with the description, serve to explain the features, advantages, and principles of the invention.
FIG. 1 is a diagram of a process in accordance with an embodiment of this invention.
FIG. 2 is a series of cross-sectional views of portions of photovoltaic cells that can be made using a process the same as or similar to the process in FIG. 1.
FIG. 3 is a diagram of a process in accordance with another embodiment of this invention.
FIG. 4 is a series of cross-sectional views of portions of photovoltaic cells that can be made using a process the same as or similar to the process in FIG. 3.
FIG. 5 is a diagram of a process in accordance with yet another embodiment of this invention.
FIG. 6 is a series of cross-sectional views of portions of photovoltaic cells that can be made using a process the same as or similar to the process in FIG. 5.
FIG. 7 is a diagram of a process in accordance with still another embodiment of this invention.
FIG. 8 is a series of cross-sectional views of portions of photovoltaic cells that can be made using a process the same as or similar to the process in FIG. 7.
FIG. 9 is a diagram of a process in accordance with a further embodiment of this invention.
FIG. 10 is a series of cross-sectional views of portions of photovoltaic cells that can be made using a process the same as or similar to the process in FIG. 9.
FIG. 11 is a diagram of a process in accordance with an additional embodiment of this invention.
FIG. 12 is a series of cross-sectional views of portions of photovoltaic cells that can be made using a process the same as or similar to the process in FIG. 11.
FIG. 13 is a plan view of an array of laser-processed contacts.
FIG. 14 is a diagram of a tophat laser beam shaper set-up.
FIGS. 15 and 16 are diagrams illustrating the effects of temporal pulse-shaping of a laser beam.
FIG. 17A is a graphical illustration of a temporal profile for laser firing.
FIG. 17B is a graphical illustration of a temporal profile for laser doping.
FIGS. 18-21 are photographs of actual laser-fired contacts, showing a progression of the effects of additional laser pulses.
FIG. 22 is a diagram illustrating the formation of an isolation gap.

### Detailed Description of the Invention

Several techniques can be employed either alone or in combination to reduce laser-induced damage in forming laser-processed contacts in the manufacture of photovoltaic cells. In particular, the methods described herein can be used in the manufacture of back-contact photovoltaic cells.

The photovoltaic cell is formed using a semiconductor wafer that comprises silicon. A passivation layer and a dielectric layer, or a dielectric passivation layer, is deposited on one or both surfaces of the wafer. A doping layer is deposited on at least part of one or both surfaces of the wafer. The doping layer may be deposited on the wafer either before or after depositing the passivation layer and the dielectric layer, or the dielectric passivation layer, on the wafer. An electrical contact layer, which comprises a metal, is deposited over at least the dielectric layer or the dielectric passivation layer in the region containing the doping layer. Laser processing may be carried out either before or after depositing the electrical contact layer. By spatially and/or temporally pulse-shaping the laser beam, the amount of laser-induced damage can be greatly reduced.

In a broader sense, the methods described herein can be used for forming an electrical contact between an electrical conducting layer and a second layer, where there is at least a third layer positioned between the electrical conducting layer and the second layer. More particularly, the methods include depositing a passivation layer and a dielectric layer, or a dielectric passivation layer, on at least one surface of the third layer; depositing a doping layer on a region of at least one surface of the third layer; depositing the electrical conducting layer over at least the dielectric layer or the dielectric passivation layer in the region containing the doping layer; and spatially and/or temporally pulse-shaping a laser beam during laser processing to greatly reduce the amount of laser-induced damage.

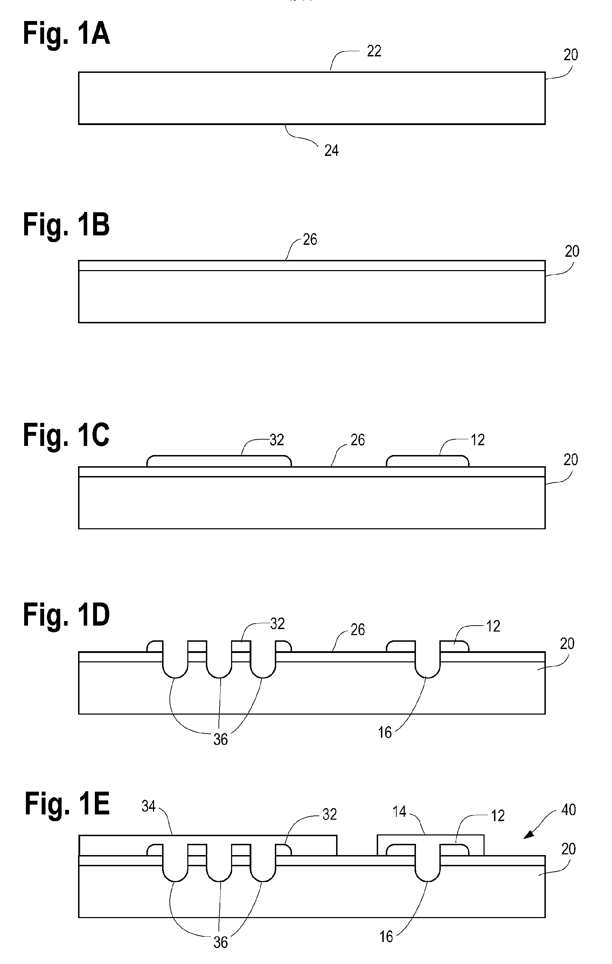

Certain embodiments of the invention will now be described with respect to the Figures. The Figures are not necessarily drawn to scale. For example, the thickness of the various metals, semiconductor and other layers shown in the Figures are not necessarily in scale with respect to each other. In FIGS. 1-12, a back surface of the photovoltaic cell 20 is facing up. Thus, the front or light-receiving surface of the cell 20 is facing down.

In one embodiment, the method starts with a silicon wafer 20, as shown in FIG. 1A. As shown in FIG. 1B, a dielectric passivation layer 26 is deposited on a first surface 22 of the wafer 20. In alternative processing steps, not shown in FIG. 1, the dielectric passivation layer 26 may be deposited on a second surface 24 of the wafer 20 or on both the first 22 and second 24 surfaces of the wafer 20. In the next step, as shown in FIG. 1C, a doping layer 32 is deposited on a region of the first surface 22, the second surface 24, or both surfaces 22, 24, of the wafer 20. Another doping layer 12 of opposite type to that in layer 32 may be deposited on another region of the first surface 22. In the next step, as shown in FIG. 1D, a laser beam is directed at the surface of the wafer 20 in the region containing the doping layer 32 to carry out laser doping of one type of contact. Another laser beam may be directed at the surface of the wafer 20 in the region containing the other doping layer 12 to carry out laser doping of the other type of contact, such that one laser doping step creates n+ contacts while the other creates p+ contacts. These steps result in laser-processed contacts, namely laser-doped contacts 36 and 16. In a laser doping process, a laser beam irradiates a thin layer of dopant material on the silicon surface causing localized melting of the silicon and allowing the dopant to diffuse into the molten silicon. For purposes of illustration, three laser-processed contacts are shown in the figure for laser-doped contacts 36 and one laser-processed contact is shown for laser-doped contacts 16, but any number of contacts can be generated. In the next step, as shown in FIG. 1E, an electrical contact layer 34 comprising a metal is deposited over at least the dielectric passivation layer 26 in the region containing the laser-doped contacts 36 and another electrical contact layer 14 comprising a metal is deposited over at least the dielectric passivation layer 26 in the region containing the laser-doped contact 16, thus resulting in a back-contact photovoltaic cell 40. The electrical contact layers 34 and 14 may be deposited as interdigitated fingers on the rear surface of the back-contact photovoltaic cell 40 where one finger pattern contacts the laser-doped n+ contacts and the other finger pattern contacts the laser-doped p+ contacts.

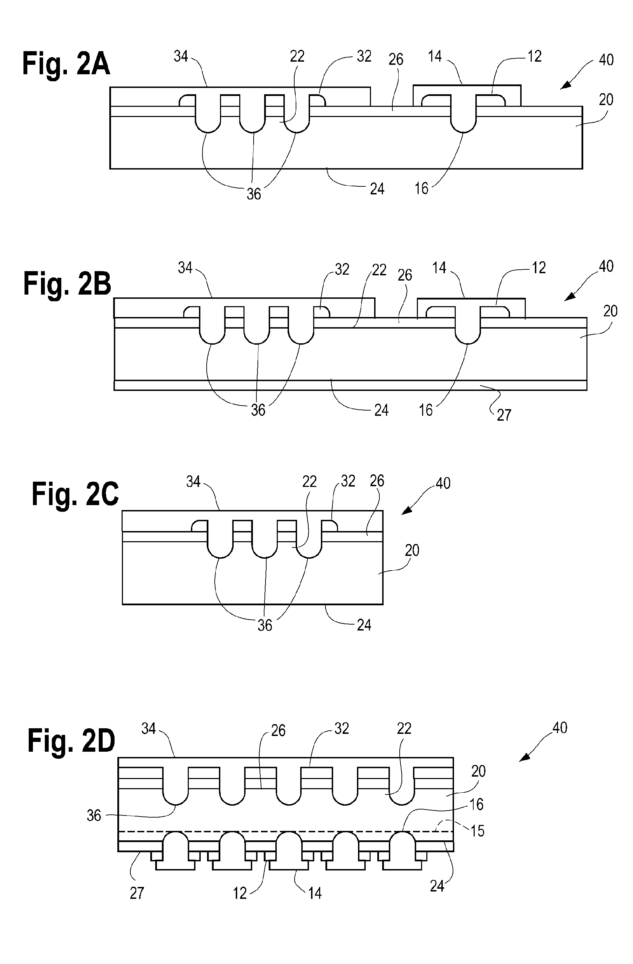

FIG. 2 illustrates various embodiments of photovoltaic cells 40 that can be made using a process the same as or similar to the process illustrated and described with respect to FIG. 1. The elements numbered in FIGS. 2-12 that are the same as in FIG. 1 are numbered the same. The photovoltaic cell 40 in FIG. 2A is essentially the same as the photovoltaic cell 40 resulting in the final steps in FIG. 1E. The photovoltaic cell 40 in FIG. 2B has a dielectric passivation layer 27 on the second surface 24 of the wafer 20 as well as the dielectric passivation layer 26 on the first surface 22 of the wafer 20. The dielectric passivation layer 27 would also function as an antireflection layer or as part of an antireflection layer on the second surface 24 of the wafer 20. The photovoltaic cell 40 in FIG. 2C is essentially the same as the cell 40 in FIG. 2A, but only the laser-doped contacts 36 are formed on the first surface 22, namely the rear surface, of the wafer 20. The photovoltaic cell 40 in FIG. 2D is essentially a conventional front-contact-to-rear-contact solar cell, instead of being a back-contact photovoltaic cell as shown in Fig. 1E. The laser-doped contacts 16 are formed on the second (front) surface 24 of the wafer 20. In FIG. 2D, laser-doped contacts 36 are formed on the first surface 22 and laser-doped contacts 16 of an opposite type are formed on the second surface 24 of the wafer 20 to form a photovoltaic cell 40. A metal 34 is deposited on the entire rear surface 22 to form an electrical contact to the laser-doped contacts 36 while a metal finger pattern 14 is deposited over the laser-doped contacts 16 on the front surface 24. Also shown in FIG. 2D is a shallow or induced emitter 15 just beneath the front surface 24. Minority carriers that diffuse to the shallow or induced emitter are transported to the laser-doped contacts 16, and the current is then carried to the external circuit through the metal finger pattern 14.

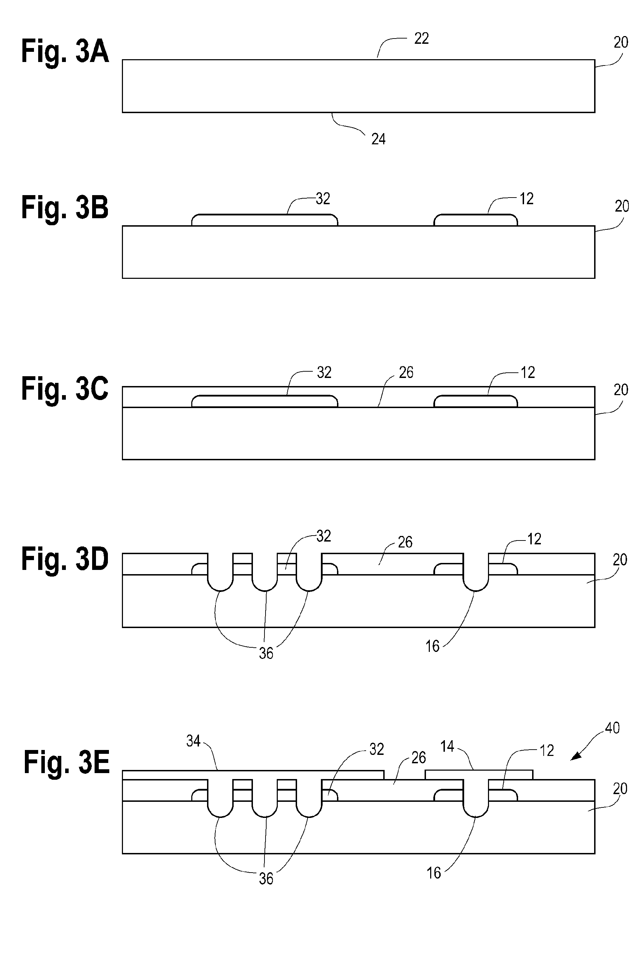

In another embodiment, illustrated in FIG. 3, the method starts with a silicon wafer 20 (FIG. 3A). As shown in FIG. 3B, a doping layer 32 is deposited on a region of the first surface 22 of the wafer 20. In alternative processing steps, not shown in FIG. 3, the doping layer 32 may be deposited on the second surface 24 of the wafer 20 or on both the first 22 and second 24 surfaces of the wafer 20. In the next step, as shown in FIG. 3C, a dielectric passivation layer 26 is deposited on the first surface 22, the second surface 24, or both the first 22 and second 24 surfaces of the wafer 20 including the surface containing the doping layer 32. In the next step, as shown in FIG. 3D, a laser beam is directed at the surface of the wafer 20 in the region containing the doping layer 32 to carry out laser doping. This step results in laser-processed contacts, namely laser-doped contacts 36. Again, for purposes of illustration, three laser-processed contacts are shown in the figure, but any number of contacts can be generated. In the next step, as shown in FIG. 3E, an electrical contact layer 34 comprising a metal is deposited over at least the dielectric passivation 26 layer in the region that was exposed to the laser beams, thus resulting in a silicon wafer with one type of laser-processed contact. As described earlier, one can make a back-contact photovoltaic cell 40 by also depositing a doping layer 12 of the opposite type to doping layer 32 in different regions of the same surface of the wafer 20 and also depositing the dielectric passivation layer over the doping layer 12. One then directs a laser beam at the surface of the wafer containing the doping layer 12 to carry out laser doping. Thus, the laser doping of layer 32 creates one type of laser-doped contact (e.g. n+ contacts) while the laser doping of layer 12 creates the other type of laser-doped contact (e.g. p+ contacts).

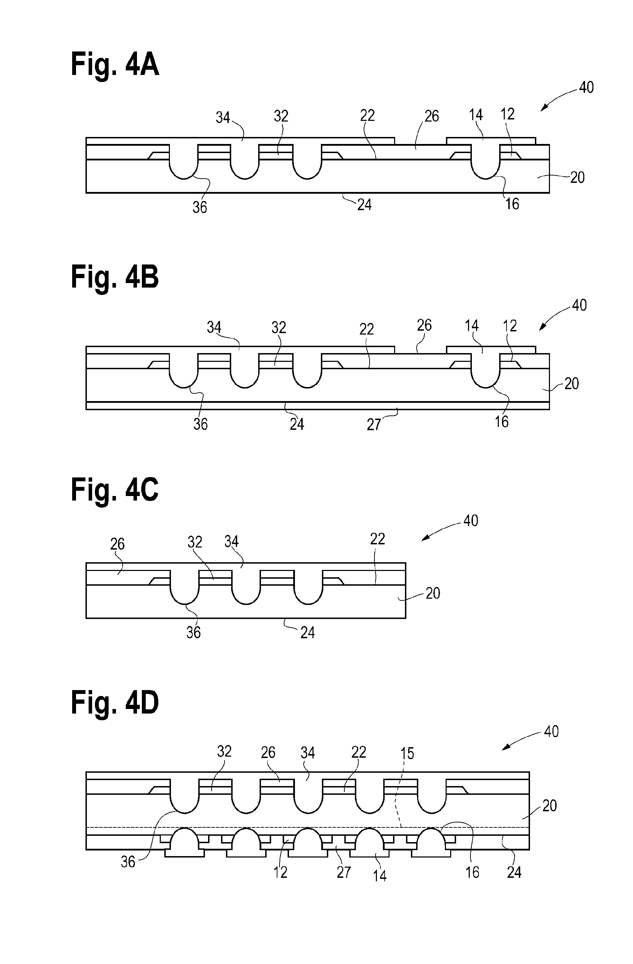

FIG. 4 illustrates various embodiments of photovoltaic cells 40 that can be made using a process the same as or similar to the process illustrated and described with respect to FIG. 3. The photovoltaic cell 40 in FIG. 4A is essentially the same as the photovoltaic cell 40 resulting in the final step in FIG. 3E. The photovoltaic cell 40 in FIG. 4B has a dielectric passivation layer 27 on the second surface 24 of the wafer 20 as well as the dielectric passivation layer 26 on the first surface 22 of the wafer 20. The photovoltaic cell 40 in FIG. 4C is essentially the same as the cell 40 in FIG. 4A, but only the laser-doped contacts 36 are formed on the first surface 22, namely the rear surface, of the wafer 20. The photovoltaic cell 40 in FIG. 4D is essentially a conventional front-contact-to-rear-contact solar cell, instead of being a back-contact photovoltaic cell as shown in FIG. 3E. The laser-doped contacts 16 are formed on the second (front) surface 24 of the wafer 20. In FIG. 4D, laser-doped contacts 36 are formed on the first surface 22 and laser-doped contacts 16 of an opposite type are formed on the second surface 24 of the wafer 20 to form a photovoltaic cell 40. A metal 34 is deposited on the entire rear surface 22 to form an electrical contact to the laser-doped contacts 36 while a metal finger pattern 14 is deposited over the laser-doped contacts 16 on the front surface 24. Also shown in FIG. 4D is a shallow or induced emitter 15 just beneath the front surface 24. Minority carriers that diffuse to the shallow or induced emitter are transported to the laser-doped contacts 16, and the current is then carried to the external circuit through the metal finger pattern 14.

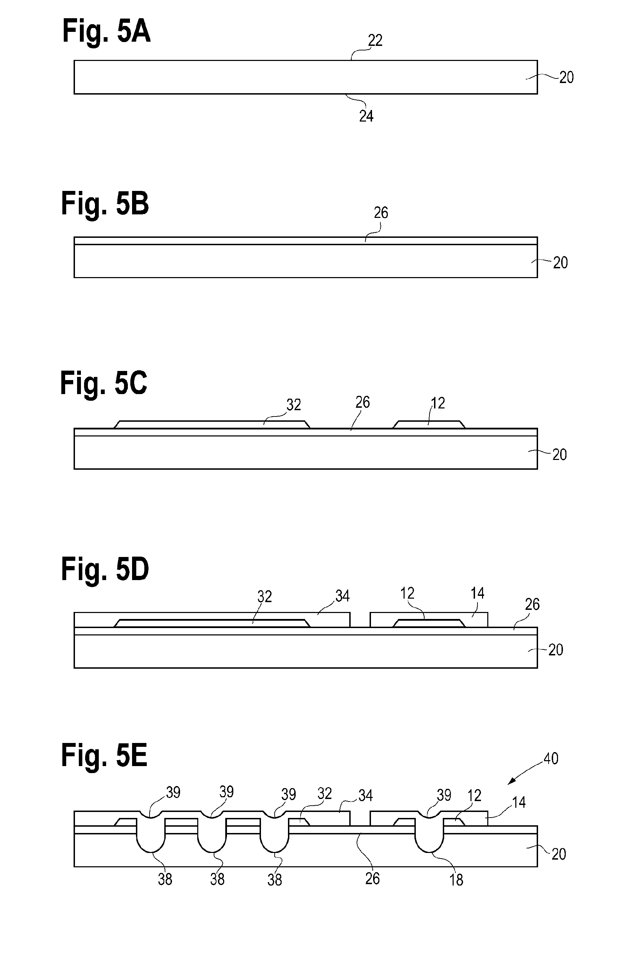

In yet another embodiment, illustrated in FIG. 5, the method starts with a silicon wafer 20 (FIG. 5A). As shown in FIG. 5B, a dielectric passivation layer 26 is deposited on the first surface 22 of the wafer 20. In alternative processing steps, not shown in FIG. 5, the dielectric passivation layer 26 may be deposited on the second surface 24 of the wafer 20 or on both the first 22 and second 24 surfaces of the wafer 20. In particular, different types of material could be used to form the dielectric layers on the front and rear surfaces. Even in a case where thin aluminum oxide layers are deposited as passivation layers on both the front and rear surfaces, the aluminum oxide could be overcoated with silicon nitride on the front to act as an antireflection layer and the aluminum oxide could be overcoated with silicon oxide on the rear to act as a rear surface reflector in combination with the metal electrodes, with the interdigitated fingers in a back-contact cell covering most of the rear surface except for the gap between the fingers. In the next step, as shown in FIG. 5C, a doping layer is deposited on a region of the first surface 22, the second surface 24, or both the first 22 and second 24 surfaces of the wafer 20. Another doping layer 12 of opposite type to that in layer 32 may be deposited on another region of the first surface 22. In the next step, as shown in FIG. 5D, an electrical contact layer 34 comprising a metal is deposited over at least the dielectric passivation layer 26 in the region containing the doping layer 32, and another electrical contact layer 14 comprising a metal is deposited over at least the dielectric passivation layer 26 in the region containing the doping layer 12. In the next step, as shown in FIG. 5E, a laser beam is directed at the surface of the wafer 20 in the region containing the doping layer 32 to carry out laser firing. Another laser beam may be directed at the surface of the wafer 20 in the region containing the other doping layer 12 to carry out laser processing of the other type of contact, such that one laser processing step creates n+ contacts while the other creates p+ contacts. These final steps result in laser-processed contacts, namely laser-fired contacts 38 and 18, thus resulting in a back-contact photovoltaic cell 40. As shown in FIG. 5E, indentations or depressions 39, which can be crater-like in appearance, are formed on the surface of the electrical contact layers 34 and 14 where the laser beams were positioned to form the laser-fired contacts 38 and 18. For purposes of illustration, three laser-processed contacts are shown in the figure for laser-fired contacts 38 and one laser-processed contact is shown for laser-fired contacts 18, but any number of contacts can be generated.

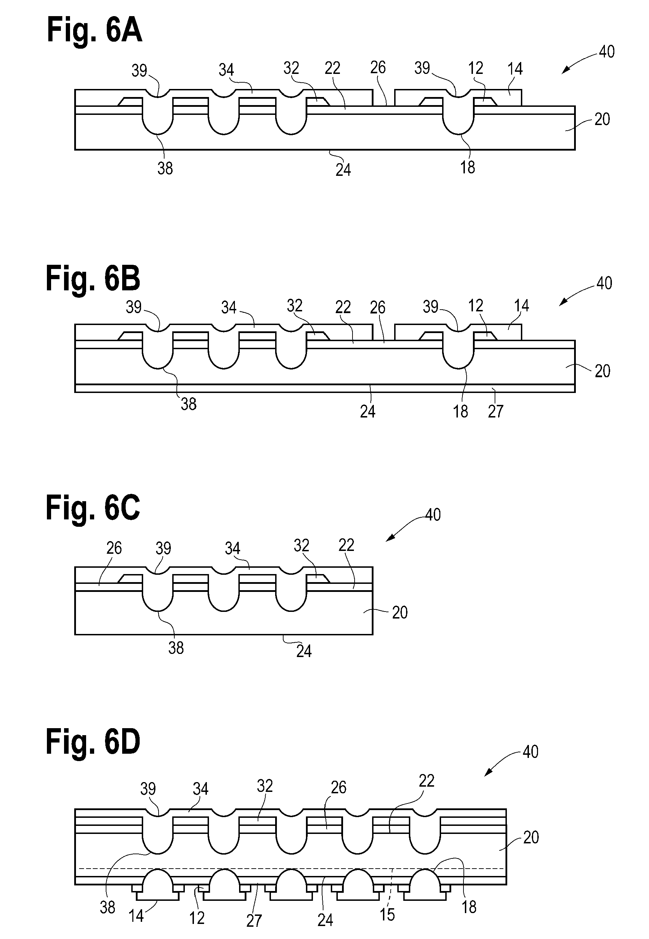

FIG. 6 illustrates various embodiments of photovoltaic cells 40 that can be made using a process the same as or similar to the process illustrated and described with respect to FIG. 5. The photovoltaic cell 40 in FIG. 6A is essentially the same as the photovoltaic cell 40 resulting in the final step in FIG. 5E. The photovoltaic cell 40 in FIG. 6B has a dielectric passivation layer 27 on the second surface 24 of the wafer 20 as well as the dielectric passivation layer 26 on the first surface 22 of the wafer 20. The photovoltaic cell 40 in FIG. 6C is essentially the same as the cell 40 in FIG. 6A, but only the laser-fired contacts 38 are formed on the first surface 22, namely the rear surface, of the wafer 20. The photovoltaic cell 40 in FIG. 6D is essentially a conventional front-contact-to-rear-contact solar cell, instead of being a back-contact photovoltaic cell as shown in FIG. 5E. In FIG. 6D, laser-fired contacts 38 forming contacts of one doping type (e.g. n+ contacts) are formed on the first surface 22 and laser-fired contacts 18 forming contacts of an opposite type (e.g. p+ contacts) are formed on the second surface 24 of the wafer 20 to form a photovoltaic cell 40. A metal 34 is deposited on the entire rear surface 22 to form an electrical contact to the laser-fired contacts 38 while a metal finger pattern 14 is deposited over the laser-fired contacts 18 on the front surface 24. Also shown in FIG. 6D is a shallow or induced emitter 15 just beneath the front surface 24. Minority carriers that diffuse to the shallow or induced emitter are transported to the laser-fired contacts 18, and the current is then carried to the external circuit through the metal finger pattern 14.

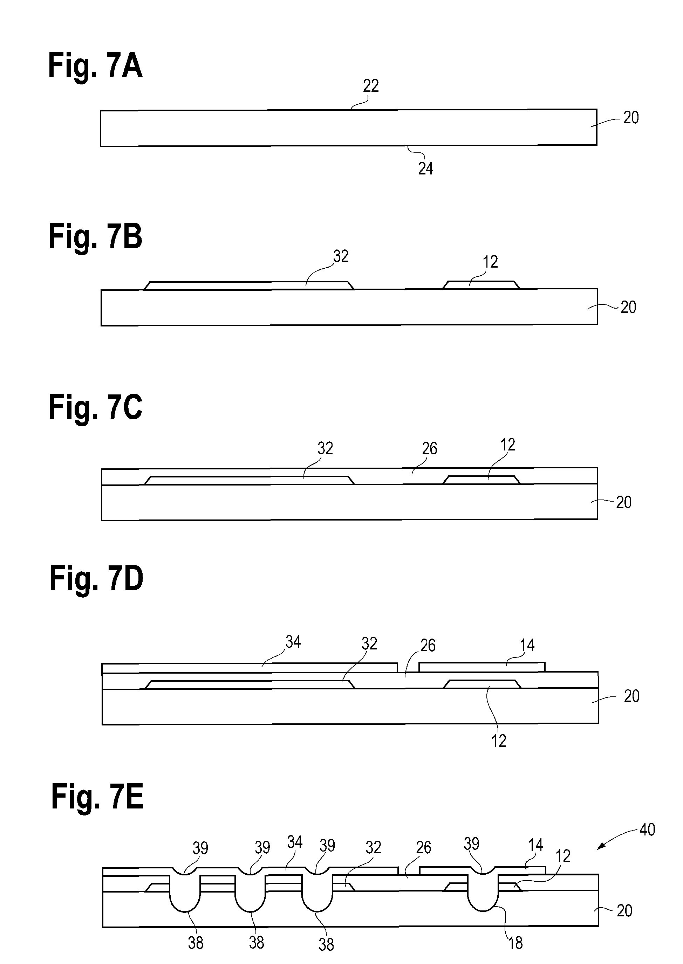

In still another embodiment, illustrated in FIG. 7, the method starts with a silicon wafer 20 (FIG. 7A). As shown in FIG. 7B a doping layer 32 is deposited on a region of the first surface 22 of the wafer 20. Another doping layer 12 of opposite type to that in layer 32 may be deposited on another region of the first surface 22. In alternative processing steps, not shown in FIG. 7, the doping layer 32 may be deposited on a region of the second surface 24 of the wafer 20 or on both the first 22 and second 24 surfaces of the wafer 20. In the next step, as shown in FIG. 7C, a dielectric passivation layer 26 is deposited on the first surface 22, the second surface 24, or both the first 22 and second 22 surfaces of the wafer 20 including the surface containing the doping layer 32 and the doping layer 12. In the next step, as shown in FIG. 7D, an electrical contact layer 34 comprising a metal is deposited over at least the dielectric passivation layer 26 in the region containing the doping layer 32 and another electrical contact layer 14 comprising a metal is deposited over at least the dielectric passivation layer 26 in the region containing the doping layer 12. In the next step, as shown in FIG. 7E, a laser beam is directed at the surface of the wafer 20 in the region containing the doping layer 32 to carry out laser firing. Another laser beam may be directed at the surface of the wafer 20 in the region containing the other doping layer 12 to carry out laser processing of the other type of contact, such that one laser processing step creates n+ contacts while the other creates p+ contacts. These final steps result in laser-processed contacts, namely laser-fired contacts 38 and 18, thus resulting in a back-contact photovoltaic cell 40. As shown in FIG. 7E, indentations or depressions 39, which can be crater-like in appearance, are formed on the surface of the electrical contact layers 34 and 14 where the laser beams were positioned to form the laser-fired contacts 38 and 18. For purposes of illustration, three laser-processed contacts are shown in the figure for laser-fired contacts 38 and one laser-processed contact is shown for laser-fired contacts 18, but any number of contacts can be generated.

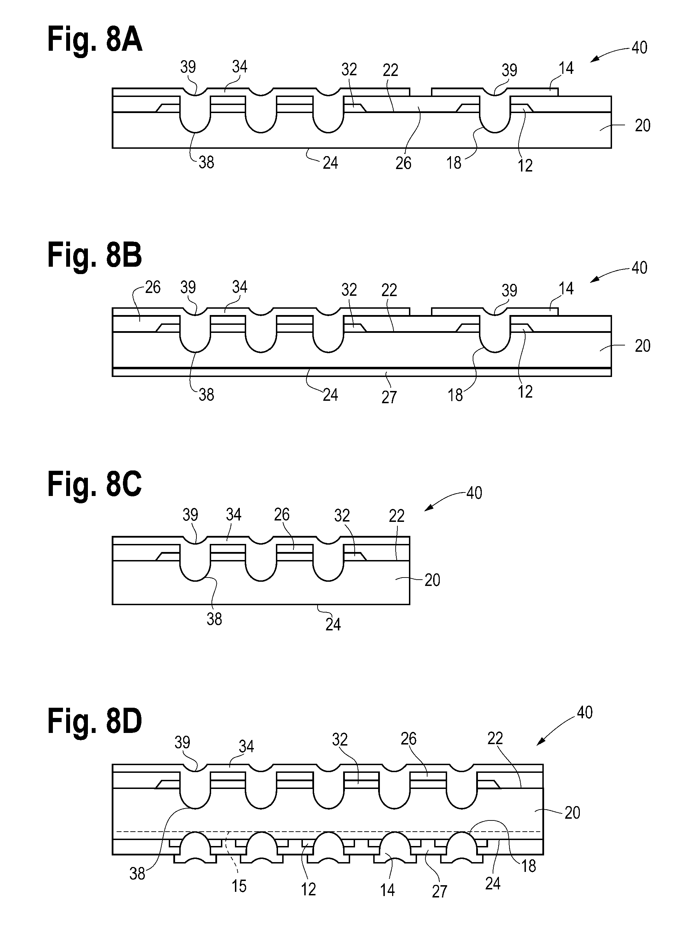

FIG. 8 illustrates various embodiments of photovoltaic cells 40 that can be made using a process the same as or similar to the process illustrated and described with respect to FIG. 7. The photovoltaic cell 40 in FIG. 8A is essentially the same as the photovoltaic cell 40 resulting in the final step in FIG. 7E. The photovoltaic cell 40 in FIG. 8B has a dielectric passivation layer 27 on the second surface 24 of the wafer 20 as well as the dielectric passivation layer 26 on the first surface 22 of the wafer 20. The photovoltaic cell 40 in FIG. 8C is essentially the same as the cell 40 in FIG. 8A, but only the laser-fired contacts 38 are formed on the first surface 22, namely the rear surface, of the wafer 20. The photovoltaic cell 40 in FIG. 8D is essentially a conventional front-contact-to-rear-contact solar cell, instead of being a back-contact photovoltaic cell as shown in FIG. 7E. In FIG. 8D, laser-fired contacts 38 forming contacts of one doping type (e.g. n+ contacts) are formed on the first surface 22 and laser-fired contacts 18 forming contacts of an opposite type (e.g. p+ contacts) are formed on the second surface 24 of the wafer 20 to form a photovoltaic cell 40. A metal 34 is deposited on the entire rear surface 22 to form an electrical contact to the laser-fired contacts 38 while a metal finger pattern 14 is deposited over the laser-fired contacts 18 on the front surface 24. Also shown in FIG. 8D is a shallow or induced emitter 15 just beneath the front surface 24. Minority carriers that diffuse to the shallow or induced emitter are transported to the laser-fired contacts 18, and the current is then carried to the external circuit through the metal finger pattern 14.

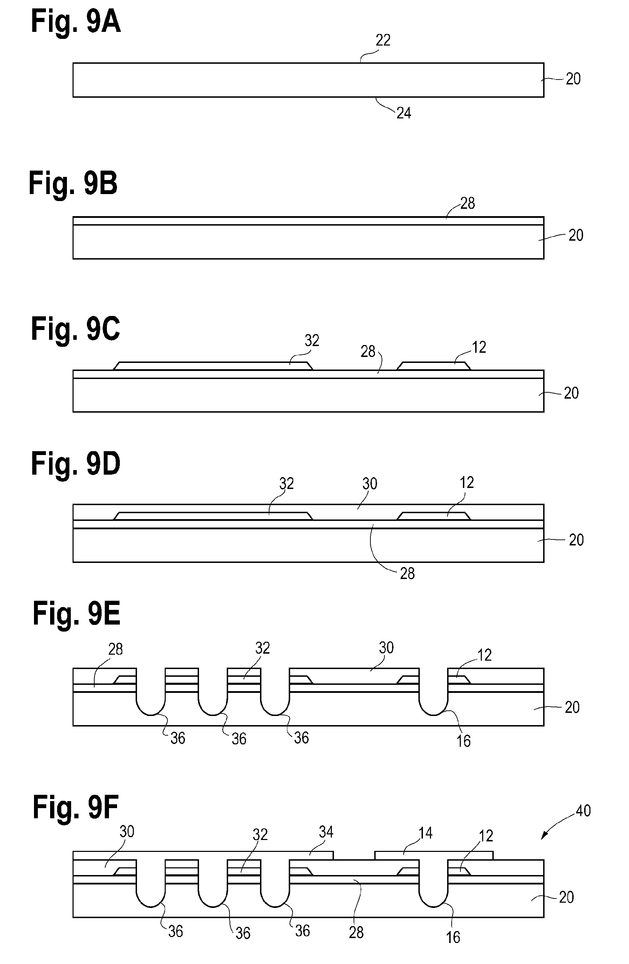

In a further embodiment, illustrated in FIG. 9, the method starts with a silicon wafer 20 (FIG. 9A). As shown in FIG. 9B, a thin passivation layer 28 is deposited on the first surface 22 of the wafer 20. In alternative processing steps, not shown in FIG. 9, the passivation layer 28 may be deposited on the second surface 24 of the wafer 20 or on both the first 22 and second 24 surfaces of the wafer 20. In the next step, as shown in FIG. 9C, a doping layer 32 is deposited on a region of the first surface 22, the second surface 24, or both the first 22 and second 24 surfaces of the wafer 20. Another doping layer 12 of opposite type to that in layer 32 may be deposited on another region of the same surface or surfaces. In the next step, as shown in FIG. 9D, a dielectric layer 30 is deposited on the first surface 22, the second surface 24, or both the first 22 and second 24 surfaces of the wafer 20 including the surface containing the doping layer 32 and the doping layer 12. In the next step, as shown in FIG. 9E, a laser beam is directed at the surface of the wafer 20 in the region containing the doping layer 32 to carry out laser doping. Another laser beam may be directed at the surface of the wafer 20 in the region containing the other doping layer 12 to carry out laser processing of the other type of contact, such that one laser processing step creates n+ contacts while the other creates p+ contacts. These steps result in laser-processed contacts, namely laser-doped contacts 36 and laser-doped contacts 16. Again, for purposes of illustration, three laser-processed contacts are shown in the figure for laser-doped contacts 36 and one laser-processed contact is shown for laser-doped contacts 16, but any number of contacts can be generated. In the next step, as shown in FIG. 9F, electrical contact layers 34 and 14, each comprising a metal, are deposited over at least the dielectric/passivation layer 30/28 in the regions that were exposed to the laser beams, thus resulting in a photovoltaic cell 40.

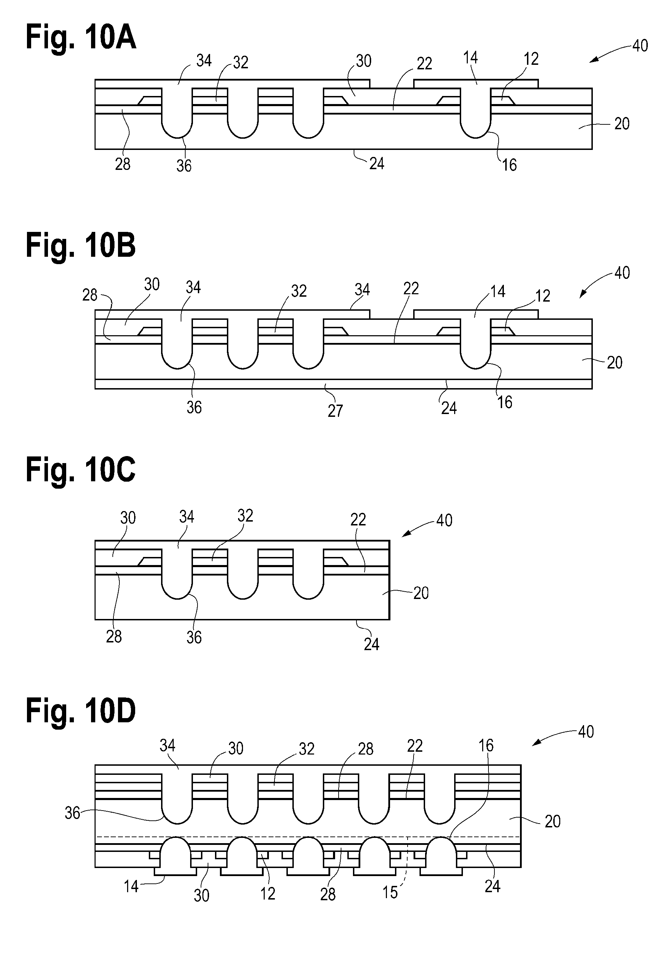

FIG. 10 illustrates various embodiments of photovoltaic cells 40 that can be made using a process the same as or similar to the process illustrated and described with respect to FIG. 9. The photovoltaic cell 40 in FIG. 10A is essentially the same as the photovoltaic cell 40 resulting in the final step in FIG. 9F. The photovoltaic cell 40 in FIG. 10B has a dielectric passivation layer 27 on the second surface 24 of the wafer 20 as well as the dielectric/passivation layer 30/28 on the first surface 22 of the wafer 20. The photovoltaic cell 40 in FIG. 10C is essentially the same as the cell 40 in FIG. 10A, but only the laser-doped contacts 36 are formed on the first surface 22, namely the rear surface, of the wafer 20. The photovoltaic cell 40 in FIG. 10D is essentially a conventional front-contact-to-rear-contact solar cell, instead of being a back-contact photovoltaic cell as shown in FIG. 9F. In FIG. 10D, laser-doped contacts 36 are formed on the first surface 22 and laser-doped contacts 16 of the opposite doping type are formed on the second surface 24 of the wafer 20. A metal 34 is deposited on the entire rear surface 22 to form an electrical contact to the laser-doped contacts 36 while a metal finger pattern 14 is deposited over the laser-doped contacts 16 on the front surface 24. Also shown in FIG. 10D is a shallow or induced emitter 15 just beneath the front surface 24. Minority carriers that diffuse to the shallow or induced emitter are transported to the laser-doped contacts 16, and the current is then carried to the external circuit through the metal finger pattern 14.

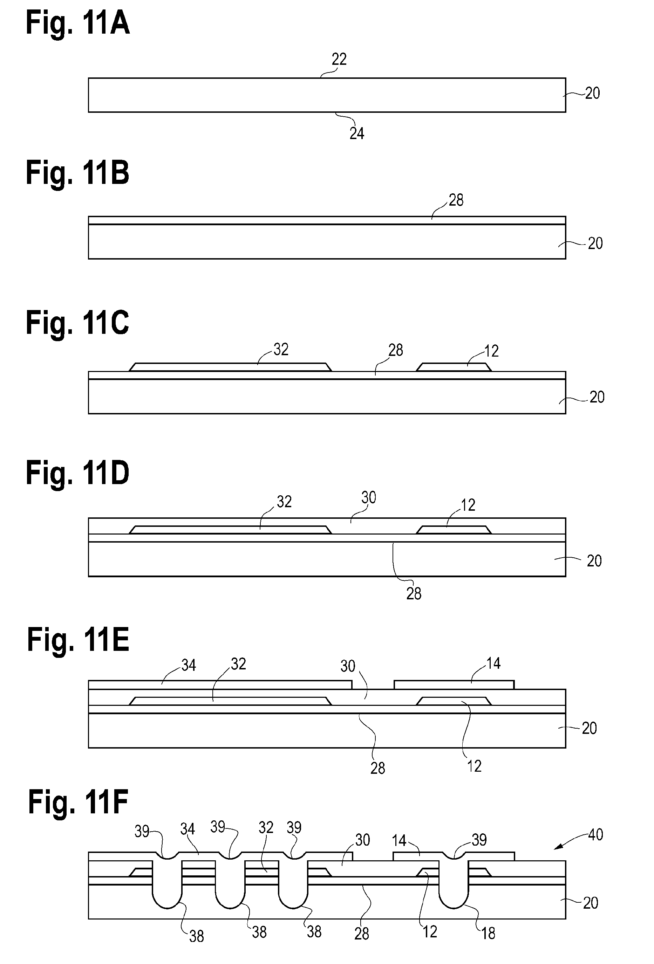

In an additional embodiment, illustrated in FIG. 11, the method starts with a silicon wafer 20 (FIG. 11A). As shown in FIG. 11B, a thin passivation layer 28 is deposited on the first surface 22 of the wafer 20. In alternative processing steps, not shown in FIG. 11, the passivation layer 28 may be deposited on the second surface 24 of the wafer 20 or on both the first 22 and second 24 surfaces of the wafer 20. In the next step, as shown in FIG. 11C, a doping layer 32 is deposited on a region of the first surface 22, the second surface 24, or both the first 22 and second 24 surfaces of the wafer 20. Another doping layer 12 of opposite type to that in layer 32 may be deposited on another region of the same surface or surfaces. In the next step, as shown in FIG. 11D, a dielectric layer 30 is deposited on the first surface 22, the second surface 24, or both the first 22 and second 24 surfaces of the wafer 20 including the surface containing the doping layer 32 and the doping layer 12. In the next step, as shown in FIG. 11E, an electrical contact layer 34 comprising a metal is deposited over at least the dielectric/passivation layer 30/28 in the region containing the doping layer 32 and another electrical contact layer 14 comprising a metal is deposited over at least the dielectric/passivation layer 30/28 in the region containing the doping layer 12. In the next step, as shown in FIG. 11F, a laser beam is directed at the surface of the wafer 20 in the region containing the doping layer 32 to carry out laser firing. Another laser beam may be directed at the surface of the wafer 20 in the region containing the other doping layer 12 to carry out laser processing of the other type of contact, such that one laser processing step creates n+ contacts while the other creates p+ contacts. These final steps result in laser-processed contacts, namely laser-fired contacts 38 and 18, thus resulting in a back-contact photovoltaic cell 40. As shown in FIG. 11F, indentations or depressions 39, which can be crater-like in appearance, are formed on the surface of the electrical contact layers 34 and 14 where the laser beams were positioned to form the laser-fired contacts 38 and 18. For purposes of illustration, three laser-processed contacts are shown in the figure for laser-fired contacts 38 and one laser-processed contact is shown for laser-fired contacts 18, but any number of contacts can be generated.

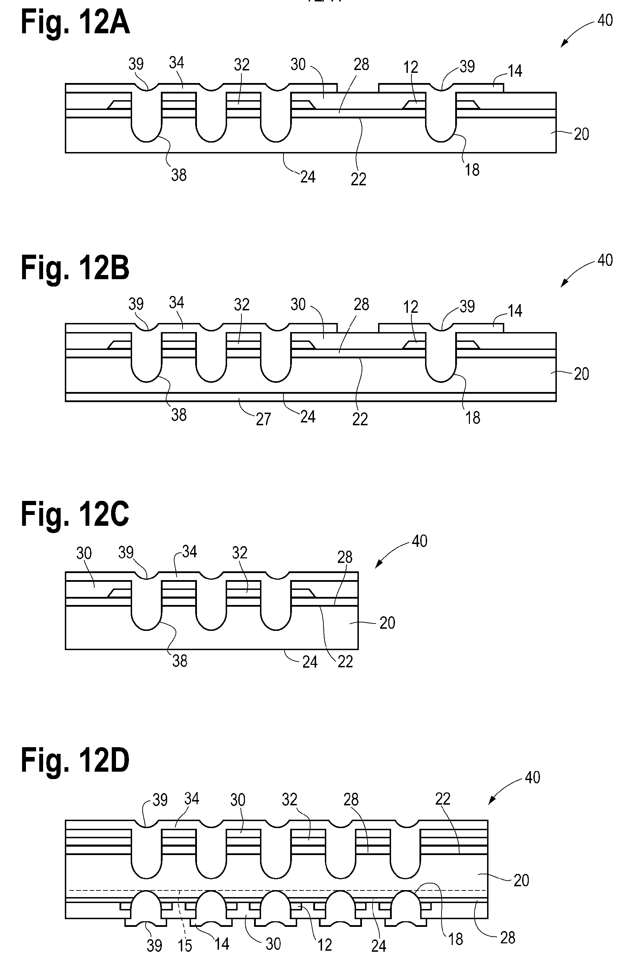

FIG. 12 illustrates various embodiments of photovoltaic cells 40 that can be made using a process the same as or similar to the process illustrated and described with respect to FIG. 11. The photovoltaic cell 40 in FIG. 12A is essentially the same as the photovoltaic cell 40 resulting in the final step in FIG. 11F. The photovoltaic cell 40 in FIG. 12B has a dielectric passivation layer 27 on the second surface 24 of the wafer 20 as well as the dielectric/passivation layer 30/28 on the first surface 22 of the wafer 20. The photovoltaic cell 40 in FIG. 12C is essentially the same as the cell 40 in FIG. 12A, but only the laser-fired contacts 38 are formed on the first surface 22, namely the rear surface, of the wafer 20. The photovoltaic cell 40 in FIG. 12D is essentially a conventional front-contact-to-rear-contact solar cell, instead of being a back-contact photovoltaic cell as shown in FIG. 11F. In FIG. 12D, laser-fired contacts 38 are formed on the first surface 22 and laser-fired contacts 18 of the opposite doping type are formed on the second surface 24 of the wafer 20. A metal 34 is deposited on the entire rear surface 22 to form an electrical contact to the laser-fired contacts 38 while a metal finger pattern 14 is deposited over the laser-fired contacts 18 on the front surface 24. Also shown in FIG. 12D is a shallow or induced emitter 15 just beneath the front surface 24. Minority carriers that diffuse to the shallow or induced emitter are transported to the laser-fired contacts 18, and the current is then carried to the external circuit through the metal finger pattern 14.

Each of the layers applied in the above methods are described in greater detail below. Additionally, when referring herein to a layer positioned over another layer or over a wafer, it does not necessarily mean that such layer is positioned directly on and in contact with such other layer or wafer. Layers of other materials may be present between such layers or between such layer and the wafer.

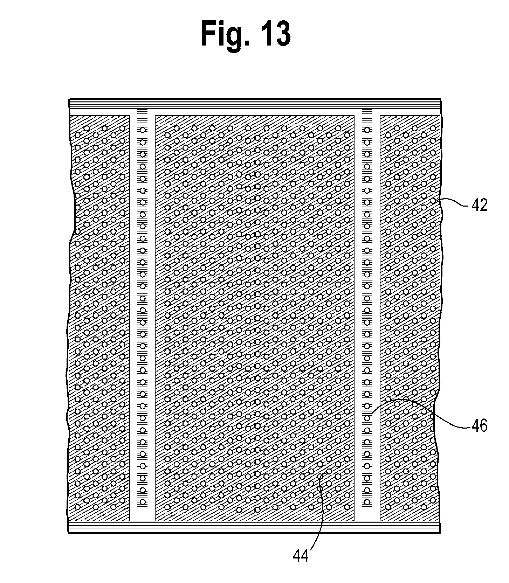

Spatial pulse-shaping of the laser beam can be achieved by splitting a single high-energy laser beam from a laser into an array of small laser beams and directing the laser beams at the surface of the wafer in the region containing the doping layer to form arrays of localized base and/or emitter contacts on at least one surface of the wafer. A plan view of such an array of laser-processed contacts 42 is illustrated in FIG. 13. One or more optical image transform components combined with regular optical components (beam expander, focal lens, etc.) by suitable optical design can be used to split the single high-energy laser beam into the array of laser beams. Examples of suitable optical components include diffractive optics, microlenses, spatial light modulators such as micromirror arrays or aperture stop arrays, or combinations of any of these components. Any suitable laser with sufficient power and a sufficient wavelength may be used to form the array of laser beams, such as a solid state laser, a fiber laser, an excimer laser, a carbon dioxide (CO₂) laser, and the like.

The resulting array of beams has small beam diameters, which results in an array of small laser-processed contacts from a single laser shot. For example, each of the beams in the array of laser-doped or laser-fired regions may have a diameter of less than about 20 microns, or less than about 10 microns. The beams have a generally uniform intensity across an entire cross section, such as to produce contacts with even penetration into the wafer. As another example, the laser-processed base contacts may be arranged in a single row of laser-fired or laser-doped regions where each localized region has a diameter of less than about 20 microns, or less than about 10 microns. Laser-induced damage is greatly reduced due to the small spot size of the laser-processed regions. The laser beams used to process the base contacts may be in the shape of a line that will align with the finger patterns.

The number of laser-processed base regions is determined by the series resistance associated with the contacts, and the total series resistance must be kept small to avoid degrading the solar cell conversion efficiency. Large area laser-processed contacts can induce significant thermal stresses in the vicinity of the laser-processed region, which in turn creates defects such as dislocations. These laser-induced defects act as recombination centers and reduce the minority carrier lifetime, which leads to poor conversion efficiencies in laser-processed solar cells. By limiting the laser-processed region to a very small area, there will be insufficient local stress to induce many dislocations, and the laser-induced damage is greatly minimized. This technique of spatial beam shaping, namely splitting a single high-energy laser beam from a laser into an array of small laser beams, can be applied to any of the methods described above and illustrated in Figures 1, 3, 5, 7, 9, and 11.

For a back-contact cell, most of the rear surface would consist of a shallow or induced emitter, and the spacing of the laser-processed "point contact" emitters would be determined by the sheet resistance of the shallow or induced emitter. For a high resistivity emitter, one would select closely spaced point contact emitters so that the spreading resistance would be small. Thus, as illustrated in FIG. 13, one could use current collection fingers that are fairly wide over the emitter region 44 and relatively narrow fingers with a high aspect ratio over the base regions 46.

A back-contact cell may also be made without a shallow emitter by using a high density of very small laser-doped or laser-fired emitters. For example, the cell may have laser-doped regions that are ∼ 3µm in diameter with a pitch of ∼20 µm. Additionally or alternatively, a back-contact cell may be made with a selective emitter by depositing a thin (sub-monolayer) of antimony nano-particle ink on the silicon wafer just before the SiNₓ deposition (such as in a PECVD entry chamber) and then laser-firing the emitters just after that.

Spatial pulse-shaping of the laser beam may also be achieved by using a line-shaped laser beam, or splitting a single high-energy laser beam from a laser into an array of line-shaped laser beams, and directing the laser beam(s) at the surface of the wafer in the region containing the doping layer to form arrays of localized base and/or emitter contacts on at least one surface of the wafer. A laser beam with a line-shaped beam can be produced using diffractive optics. Diffractive optics may be combined with beam splitting technology to create an array of line-shaped beams for rapidly producing arrays of laser-fired contacts. The line-shaped laser beams suitably have a width of less than about 20 microns, or less than about 10 microns, and a length greater than about 40 microns. For example, the line-shaped beams may be 5-10 microns wide and 100 microns to 10 cm long. Diffractive optics can also be used to create "broken" segments along lines based on the contact design.

With a line-shaped laser beam, the thermal gradient is approximately 2-dimensional, which creates fewer dislocations in both laser doping and laser firing of contacts. In the laser firing of contacts, the laser beam is incident on the surface of a metal film, which in the case of silver films is initially highly reflective, but as it heats up the optical absorption increases. The silver film conducts a significant amount of heat laterally, but the underlying dopant material and silicon will also heat up depending on the heat transfer across the interfaces. As a result of ablation and agglomeration of the silver, the laser beam will eventually (on the order of tens of nanoseconds) impinge on the underlying dopant material and the silicon. When the laser beam shape is linear, the 2-dimensional heat flow creates laser-fired contacts with a low level of laser-induced defects as compared to a conventional circular laser beam.

The line-shaped beam is advantageous for laser-firing contacts in narrow metal lines as found in front-contact fingers on many solar cells and in the narrow interdigitated fingers of back-contact cells. This is because the line-shaped laser-fired contact can be aligned to fall within the metal finger without significant disruption to the flow of current within the finger. In contrast, a conventional circular laser-fired contact with a diameter of 100 microns typically causes a significant voltage drop within the metal finger since some of the metal may be ablated and agglomerated during the laser-firing process.

New defect states associated with existing impurities can be created by laser heating even in regions that do not melt but reach temperatures of ∼850 degrees C or greater. In p-type silicon, Fe-B pairs can be dissociated creating defect levels associated with interstitial Fe, and defects involving oxygen (such as A-centers or vacancy-oxygen complexes) might be activated by laser heating through dehydrogenation. Moreover, other impurities that are passivated by hydrogen may be activated by localized laser heating due to dehydrogenation of the defect complex.

Laser-induced melting of the silicon can also create a number of defect levels that appear to be due to various vacancy-related defects and possibly interstitial-related defects which are apparently generated during the quenching process. This includes defects such as the VOH complex, the VH complex and the V₂⁻ (negatively charged divacancy). All these defects can be electrically neutralized either by hydrogenation at moderate temperatures, such as ∼350 degrees C, or by rapid thermal annealing at somewhat higher temperatures, such as 600 degrees C for 60 seconds.

Thus, one can produce laser-fired contacts without creating significant laser-induced damage by using a laser beam with a line shape (a linear spatial profile) and either subjecting the laser-fired contact to a post hydrogenation process, such as at ∼350 degrees C, or a rapid thermal processing treatment at moderate temperatures, such as ∼600-700 degrees C for 5-60 seconds. Using good quality silicon may also contribute to a reduction in laser-induced damage. In addition, n-type silicon is less susceptible to laser-induced damage than p-type silicon.

For purposes of comparison, a line-shaped laser beam of 75 mm x 10 µm and a spacing of 1 mm between lines requires about 150 lines or 300 laser-fired line-shaped contacts for a 156 mm x 156 mm wafer, resulting in an area of laser-fired contacts that is 1% of the total area. In contrast, a conventional circular laser beam with a 70µm spot size and with a 1-mm spacing requires 150 x 150 = 22,500 laser-fired contacts or 75 times more laser-fired contacts than the line-shaped pulses. The total area of the circular contacts = 22,500 x 3.76 x 10⁻⁵ cm² = 0.85 cm² or 0.35% of the total area. With less laser-induced damage from the line-shaped beam, the total recombination associated with line-shaped contacts is less than that with circular contacts even though the total contact area is ∼2.86 times larger.

A single-pulse laser typically uses an energy density of about 4.26 J/cm², or 0.16 mJ per pulse (assuming a beam radius of 35 microns). For a line-shaped pulse with dimensions of 75 mm x 20 µm with an energy density of 4.26 J/cm², the energy per pulse is 0.64 mJ, or 4 times greater than a circular pulse. Considering the reduced number of laser-fired contacts required and the greater amount of energy per pulse, the laser processing for line-shaped pulses can be done in a significantly shorter time than conventional circular pulses (∼75 times faster).

The line-shaped contacts can also be rapidly processed with a multi-nozzle aerosol jet printer. For example, an Optomec® printer with 3 heads connected together can be used for a single processing pass over the wafer, or the wafer can be moved under the printer heads. In this example, the first head could contain 75 nozzles that would dispense ∼50µm wide n+ dopant lines, the 2^{nd} head could also contain 75 nozzles and would dispense ∼ 50 µm wide p+ dopant line, and the 3^{rd} head could contain multiple nozzles that would deposit 150 Ag lines that might be 950 µm wide with 50 µm gaps between the lines. The wafer would be on a heated platen that rapidly cures the inks as they are deposited.

Thus, the line-shaped laser beam processing allows both rapid laser processing and rapid ink deposition using a multi-head, multi-nozzle aerosol jet printer. Other printing techniques such as inkjet printing or screen printing could also be used.

Another spatial pulse-shaping technique that can reduce the amount of laser-induced damage involves using a tophat laser beam shaper. Conventional laser beam profiles are Gaussian. Gaussian laser beam profiles can create isolation rings around the electric contact area with laser-fired contacts. The rings limit low contact resistance. When a Gaussian laser beam interacts with a wafer, the energy density is stronger near the center. Consequently, the ratio of the effective contact area to the total laser-fired area is lower, which means that some of the laser-processed area may make no contribution to the electrical contact. A tophat beam shaper can change a Gaussian laser beam profile to uniform distribution. More particularly, the tophat laser beam profile has a spatially uniform laser pulse that has a square shape rather than the typical Gaussian shape. When the uniform beam interacts with the wafer, the intensity is uniform. With the uniform intensity, little to no isolation ring is formed. Additionally, the uniform beam results in little to no unnecessary laser-induced damage. Tophat laser processing can also be used for other laser processes for solar cells, such as laser doping, laser scribing, and laser drilling.

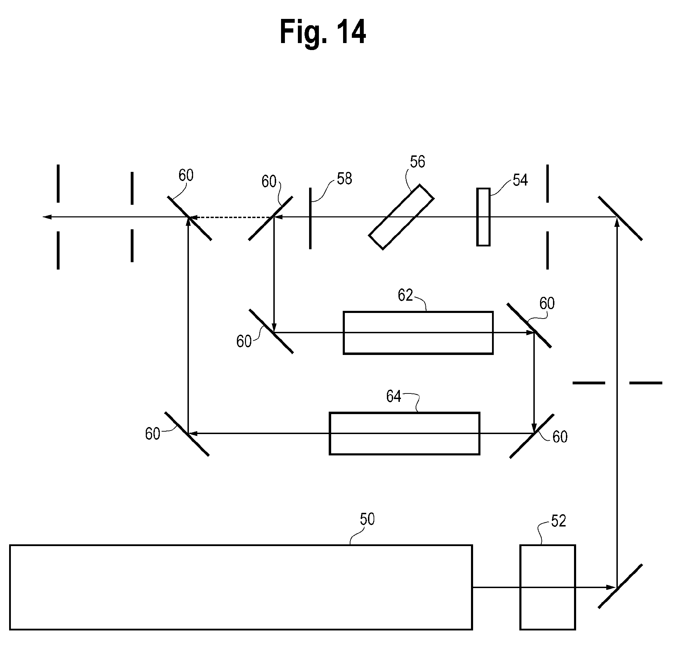

One example of a tophat laser beam shaper set-up is illustrated in FIG. 14. The laser system includes a linear polarized laser 50, an external shutter 52, a half-wave plate 54, a polarizer 56 and a λ/4 plate 58. The beam shaper assembly includes a beam expander 62 and a beam shaper 64. Tuning mirrors 60 are used to align the beam propagation path. The solid lines with arrows indicate the laser beam path with the beam shaper assembly installed. The dotted arrow indicates the original beam path without the beam shaper assembly. One of the benefits of the tophat laser beam shaper is that this technique reduces laser-induced damage without requiring any additional process steps. A tophat spatial laser beam profile may also reduce laser-induced damage by melting the metal and the silicon without significant ablation.

Another technique that can be used to reduce or eliminate the isolation ring, thereby reducing laser-induced damage, is a laser pre-treatment of the surface. When a passivating layer, such as a back surface passivation layer, is made of a multilayer of SiOₓ and SiNₓ, the processing conditions typically produce a series resistance problem evidenced by the presence of a dielectric ring (i.e., isolation ring) that surrounds the contacted area and isolates the contact from the rest of the aluminum layer. This series resistance problem is related to the Gaussian energy profile of the laser beam and the radial heat release.

By treating at least one surface of the wafer with localized annealing prior to the laser processing, the amount of laser-induced damage can be greatly reduced. In particular, a scanning head can be used to perform a defocused laser annealing leading to a partial melting of the aluminum layer. The defocusing provides a wide processing area and a smooth energy profile. Additionally, because of the defocusing, the process does not require high accuracy. For example, the pre-treatment of the surface resulted in the achievement of a contact of 77 µm diameter with no evidence of a dielectric ring, while with the same set of conditions and no pre-treatment, the contacts achieved measured 25 µm diameter surrounded by a dielectric ring of 80 µm diameter. In another example, a contact of 40 µm diameter with no dielectric ring was achieved at conditions that previously, on a non-treated area, did not even produce a measurable contact. Thus, good laser-fired contacts are obtained when the aluminum surface is partially melted by scanning with a defocused laser beam. More particularly, standard laser-fired contacts performed on the pre-treated surface are equivalent to those achieved by multiple pulses and have the benefit of a larger transformed area, absence of dielectric ring that isolates the contacted surface, lack of strict restrictions regarding thickness of the SiN layer, or SiOₓ and SiNₓ stacked layers, and a wide processing margin. The pre-treatment can be combined with either standard laser-fired contacts or any of the other laser processing contacts disclosed herein, such as laser doping, laser scribing, laser drilling, and/or applying an array of small laser beams.

As mentioned above, the amount of laser-induced damage in forming laser-induced contacts can be greatly reduced by spatially and/or temporally pulse-shaping the laser beam. Temporal pulse-shaping of the laser beam can be achieved by controlling a laser beam power density as a function of time, particularly so that the metal in the electrical contact material heats up to a temperature that ensures melting of the underlying dielectric layer or dielectric passivation layer and the surface region of the silicon wafer without boiling (ablating) the metal. By controlling the laser beam power density in this manner, only melting occurs during the contact formation and a crater is not formed (as typically occurs during a conventional "splatter" process), which reduces or prevents the occurrence of an isolation ring, thus significantly minimizing damage to the silicon wafer.

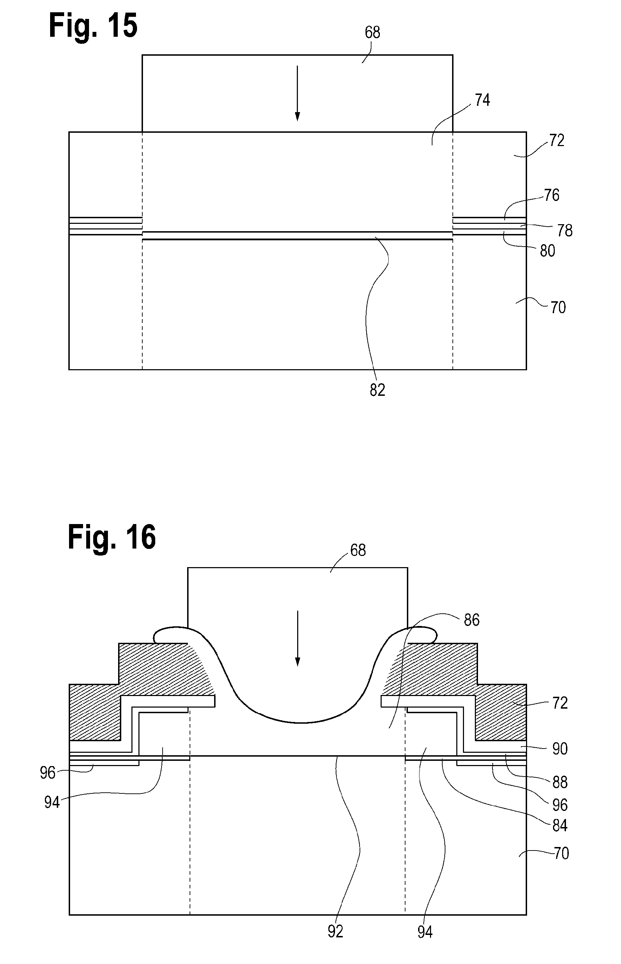

FIG. 15 illustrates the effects of temporal pulse-shaping. More particularly, an incident laser beam 68 fired at a p-type silicon wafer 70 melts the silver top contact 72 and the molten silver 74 then melts the a-Si:H layers 76, 78, 80 and a portion of the silicon wafer 70, thus allowing the dopant in the doped a-Si:H layer 78 to form a diffused emitter contact (p/n junction) 82 in the wafer 70. For an n-type wafer, boron-doped a-Si:H may be used to form the p/n junction after a laser is used to form a "melt" contact. The duration of the laser pulse should be long enough to ensure sufficient diffusion of dopants to assure a good quality semiconductor contact. For example, if the laser beam is controlled so that the silicon near the surface is molten for about 300 nanoseconds, then both the silver and the dopant (phosphorus in the figure) would diffuse ∼0.4 µm while the melt front would extend ∼5 µm into the silicon wafer. In the case of silver contacts and a-Si dielectric, the laser should heat the silver to a temperature that will melt the underlying silicon (1410°C) but less than the boiling temperature of silver (2212°C). Ideally, the laser pulse should be profiled so that the energy decreases once the silver is at the desired temperature (for example, 2000 degrees C) so that the temperature of the silver is roughly constant and does not exceed the boiling temperature.

Another example of temporal pulse-shaping is illustrated in FIG. 16. The method used to form the laser-fired contact in FIG. 16 involves aspects of both the "splatter" and "melt" processes. First, the surface of the wafer 70 is passivated with a-Si:H 84 before depositing the doped silicon ink 86 and curing it. The doped a-Si:H 88 is then deposited (to create an inversion layer 96 in the silicon wafer 70) and then a PECVD SiOₓ:H layer 90 is deposited. A silver metal contact 72 is then deposited over the regions containing the doping ink 86. The energy and pulse shape of the laser beam 68 is controlled to allow penetration through the PECVD SiOₓ:H layer 90 via ablation and the flow of molten silver and molten silicon to form a "splatter" contact that electrically connects the conductive doped silicon with the surrounding silver metal contact. The laser beam 68 is controlled so that it does not ablate all the way through the B-doped silicon ink but only through the top portion allowing contact through the PECVD oxide 90. However, the laser 68 also melts the bottom portion of the doped silicon ink 86 and part of the silicon wafer 70 allowing the dopant 86 (in this case, boron) to diffuse into the wafer 70 and form a p+/p high-low junction 92. If the as-deposited doped silicon ink 86 is resistive, then it will provide an isolation ring 94 preventing leakage from the high-low junction 92 to the induced inversion layer 96 shown in the figure.

The p+/p- high-low junction may be determined experimentally by measuring diffusion profiles using SIMS. Also, since the laser must heat the top metal layer and the underlying silicon to at least 1410 degrees C in a time that allows the dopants and silver to diffuse about 100 nm in molten silicon, the pulse duration should be at least 10 ns. Also, since the laser beam should be scanned at a speed of about 500 cm/s (in order to fire contacts with a pitch of 1 mm over a 125 mm x 125 mm wafer in about 3 seconds), the maximum pulse duration should be < 10 µs (to avoid smearing of the laser-fired contact, the beam moves ∼50 microns over 10 µs at a scan speed of 500 cm/s). Thus, lasers such as Nd-YAG lasers with a suitable energy density and pulse shape (rising rapidly at first and then tailing off over the duration of the pulse) would be capable of producing a "melt" type of laser-fired contact.

Temporal pulse-shaping can be used in combination with essentially any of the other techniques described herein for reducing laser-induced damage in forming laser-processed contacts. For example, a single high-energy laser beam from a laser can be split into an array of laser beams and directed at the surface of the wafer in the region containing the doping layer to form localized base and/or emitter contacts on at least the surface of the wafer while controlling the laser beam power density as a function of time. Additionally or alternatively, the laser beam power density can be controlled as a function of time by using a line-shaped laser beam during formation of the laser-processed contact and subsequently carrying out hydrogenation or rapid thermal processing at a temperature below about 700 degrees Celsius.

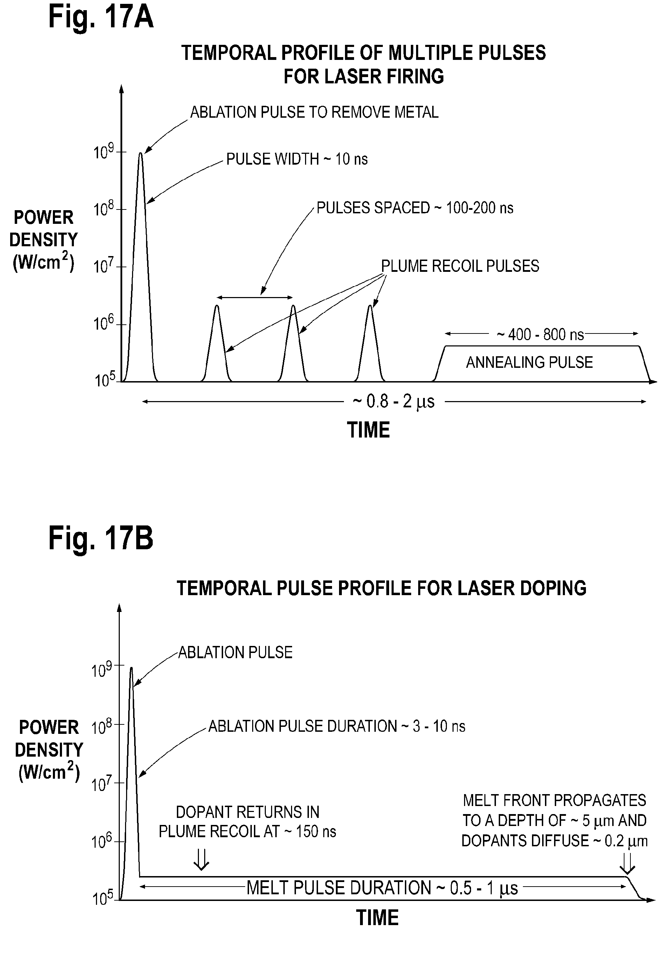

Another technique for achieving temporal pulse-shaping is the use of gated continuous wave laser pulses, which can be used to form high quality laser-fired contacts, laser-fired emitters, and/or laser-doping. The gated continuous wave (GCW) output has a short duration pulse (∼340 ns), with a power density lower than that for a pulse from a regular pulsed laser, followed by a low and long tail (with a duration of ∼70-90 µs). Multiple pulses may be required for laser-fired contacts and laser-fired emitters. More particularly, the first pulse melts and ablates the metal in the electrical contact layer, the passivation layer or dielectric passivation layer, and the first surface of the silicon wafer, followed by a low-energy tail of relatively long duration. The tail is similar to a continuous wave output. After the first pulse, the subsequent pulses drill deeper and generate a plasma plume rapidly, and the recoil of the plume splatters conductive material outward over the dielectric ring by carefully selected process parameters to create an electrical contact. The continuous wave keeps the laser-fired spot hot between pulses. The tail is the annealing stage. An example of a temporal profile for multiple laser pulses for laser firing is illustrated in FIG. 17A. An example of a temporal profile for a single laser pulse for laser doping is illustrated in FIG. 17B. The temporal pulse shaping in FIG. 17B includes a short energetic pulse to ablate the dielectric layer followed by a long, lower energy annealing pulse which keeps the silicon surface in a molten state to anneal out damage.

For example, the Oxford Nd-YAG single-pulse laser system, manufactured by Oxford Lasers Ltd. of Shirley, Massachusetts, operates at a wavelength of 1064 nm and scans at speeds of ∼10 m/s using galvanometers. Typically, the single pulse has a maximum power density of about 1.47 x 10¹² W/m² (1.47 x 10⁸ W/cm²) with a duration of 145 ns (FWHM) so the energy density is about 21.3 J/cm² at 100% laser power. At 20% of full power, this is 4.3 J/cm², which is very similar to the energy density in the pulses in the gated CW mode.

Using the Oxford Laser for a 3-pulse gated GCW mode, the first or leading part of each pulse lasts ∼340 ns (FWHM) and are 100 µs apart. The power density of the 2^{nd} part or CW part of each pulse is ~1.26 x 10¹¹ W/m² for 80% duty cycle while the power density in the CW mode is ~2.13 x 10⁹ W/m² (the CW part of the pulse is on for 80 µs for 80% laser duty cycle and off for about 20 µs). The power density of the first pulse in a 3-pulse gated CW mode is significantly less than that in subsequent pulses. The total energy density in each of the subsequent pulses is about 4.28 x 10⁴ J/m² or 4.28 J/cm² while that in the CW mode (80% duty cycle) is about 17 J/cm². However, much of the heat will dissipate during the 80 µs duration of the CW mode.

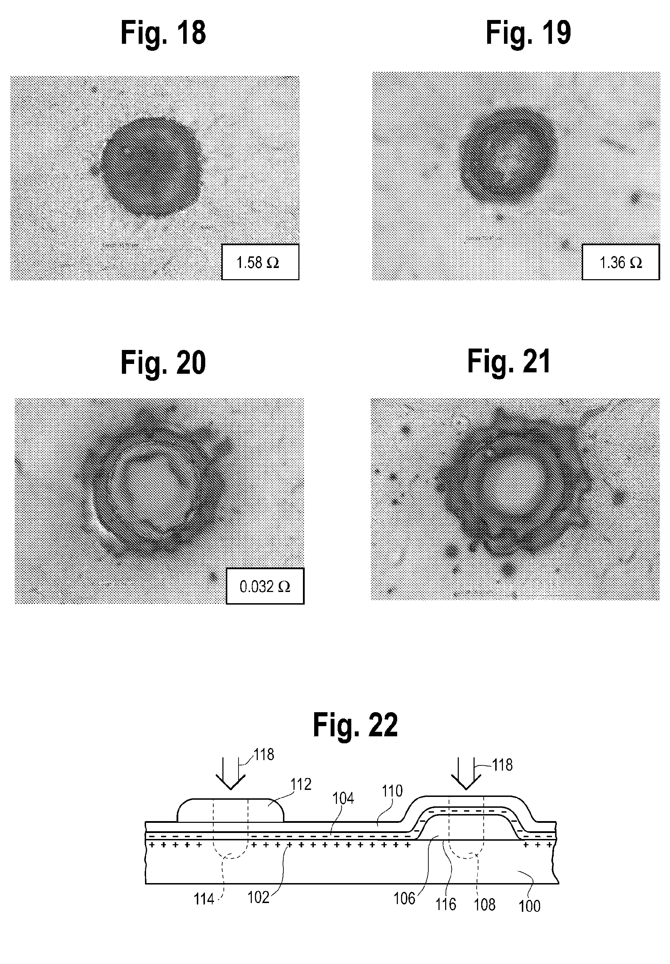

FIGS. 18-21 are photographs of actual laser-fired contacts, showing a progression of the effects of additional laser pulses. In FIG. 18, a dielectric ring is formed after a single pulse from a regular nanosecond laser at 20% power. The first laser pulse vaporizes and splatters the silver causing silver splash streaks. This pulse exposes the highly resistive intrinsic a-Si:H, which creates a large dielectric ring. There is some evidence of residual silver and silicon ablation in the central region, but it is splotchy, which may be attributable to non-uniformities in the sprayed silver ink.

FIG. 19 shows the effects of 2 gated continuous wave (GCW) pulses at 70% duty cycle. The dielectric ring (intrinsic a-Si:H) is clearly visible, as is a shallow crater in the silicon. There is also some indication of residual silver in the central region. There is not much evidence of silicon splatter or of a silicon crater wall and rim.

FIG. 20 shows the effects of 3 GCW pulses at 70% duty cycle. In this condition there is clear evidence of drilling into the silicon (∼2 µm) with an accompanying buildup of a crater wall and rim. The dielectric ring is partially overcoated with the expanding silicon wall and rim. Since the silicon wafer is heavily doped, this overcoat region provides a high conductivity path to the surrounding silver and, hence, a low resistance is measured.

FIG. 21 shows the effects of 5 GCW pulses at 70% duty cycle. The subsequent pulses drill even deeper (∼3-4 µm) and the expanding crater rim now completely overcoats the dielectric ring. These are the lowest resistance laser-fired contacts of the group, with the contact resistivity ρ_{c} = 62 µΩ-cm².

In any of the methods described herein, a second or additional electrical contact layer comprising a metal may be deposited over the region that has been laser-processed. More specifically, metalizing over regions that have been laser-fired assures low resistance contacts.

Another optional step that may be applied to any of the methods described herein is annealing the photovoltaic cell as a final step to further improve the performance of the cell. In particular, the annealing temperature may be in a range of 250 degrees Celsius to 700 degrees Celsius, and the annealing time may be in a range of about 1 second to about 30 minutes.

A semiconductor wafer useful in the process of this invention for preparing photovoltaic cells preferably comprises silicon and is typically in the form of a thin, flat shape. The semiconductor wafer may comprise one or more additional materials, such as one or more semiconductor materials, for example germanium, gallium arsenide, silicon germanium, gallium indium arsenide, indium antimonide, and the like, if desired.

Suitable silicon wafers are typically obtained by slicing or sawing silicon ingots, such as ingots of monocrystalline silicon, to form monocrystalline wafers, such as the so-called Czochralski (C_{z}) silicon wafers. Suitable wafers can also be made by slicing or sawing blocks of cast, multi-crystalline silicon. Silicon wafers can also be pulled straight from molten silicon using processes such as Edge-defined Film-fed Growth technology (EFG) or similar techniques. Although the wafers can be any shape, wafers are typically circular, square or pseudo-square in shape. "Pseudo-square" means a predominantly square shaped wafer usually with rounded corners. The wafers used in the photovoltaic cells of this invention are suitably thin. For example, wafers useful in this invention can be about 10 microns thick to about 300 microns thick. For example, they can be about 10 microns up to about 200 microns thick. They can be about 10 microns up to about 30 microns thick. If circular, the wafers can have a diameter of about 100 to about 180 millimeters, for example 102 to 178 millimeters. If square or pseudo-square, they can have a width of about 100 millimeters to about 150 millimeters with rounded corners having a diameter of about 127 to about 178 millimeters. The wafers useful in the process of this invention, and consequently the photovoltaic cells made by the process of this invention can, for example, have a surface area of about 100 to about 250 square centimeters. For back-contact solar cells, it is preferable to use thin silicon wafers (< 150 microns thick) since most photogenerated carriers are created near the front of the cell and must diffuse to the back contacts.

Although the term wafer, as used herein, includes the wafers obtained by the methods described, particularly by sawing or cutting ingots or blocks of single crystal or multi-crystalline silicon, it is to be understood that the term wafer can also include any other suitable semiconductor substrate or layer useful for preparing photovoltaic cells by the process of this invention.

The front surface of the wafer may be textured. Texturing generally increases the efficiency of the resulting photovoltaic cell by increasing light absorption. For example, the wafer can be suitably textured using chemical etching, plasma etching, laser or mechanical scribing. The back surface of the wafer may or may not be textured depending on the thickness of the wafer and the light-trapping geometry employed.

A dopant or a doping agent broadly refers to an impurity element or compound added to a crystal lattice and/or a semiconductor lattice in relatively low concentrations, such as to alter or change electrical properties of the semiconductor. Without being bound by theory, addition of a dopant to a semiconductor material may shift a Fermi level within the material, such as to result in a material with predominantly negative (n-type) charge carriers or predominantly positive (p-type) charge carriers depending on the dopant species. The doping layer may include any suitable conductivity type, such as n-type and/or p-type, and the dopants may be the opposite or same conductivity type as the wafer.

For a p-type wafer, boron is widely used as the p-type dopant, although other p-type dopants, for example, aluminum, gallium or indium, will also suffice. Boron is the preferred p-type dopant. Combinations of such dopants are also suitable. Thus, the dopant for a p-type wafer can comprise, for example, one or more of boron, aluminum, gallium or indium, and preferably it comprises boron. If an n-type silicon wafer is used, the dopants can be, for example, one or more of phosphorus, arsenic, antimony, or bismuth. The dopants can be diffused into the silicon wafer using thermal processing, rapid thermal processing (RTP), and/or the like.

The term "depositing" broadly may include any suitable action, such as printing, contact printing, screen printing, non-contact printing, inkjet printing, aerosol jet printing, brushing, coating, and/or the like. Dopant sources broadly include any suitable source or supply of the dopant atoms and/or molecules. Dopant sources may include inks, slurries, emulsions, pastes, powders, particles, nanoparticles, solutions, and/or the like. Dopant sources may include solvents, binders, flow modifiers, and/or the like. One suitable dopant source is a boron ink supplied from Filmtronics based in Butler, Pennsylvania, U.S.A. Another suitable dopant source is a phosphorus ink supplied from Cookson electronics based in Providence, Rhode Island, U.S.A. The best inks or pastes contain only (or primarily) dopant atoms and silicon atoms such as doped silicon inks from companies such as Nanogram (recently acquired by Teijin Ltd.) or frit-free aluminum pastes from companies such as DuPont. Suitable inkjet printers include Dimatix DMP model from FujiFilm Dimatix based in Santa Clara, California, U.S.A. Suitable aerosol jet printers may include the M3D 300SL model from Optomec based in Albuquerque, New Mexico, U.S.A.

One example of a highly effective dopant source is heavily doped silicon. The silicon may be a deposited layer of amorphous, microcrystalline, or crystalline silicon. The doped silicon may contain, for example, 0.05 to 5.0 at. % of either boron or phosphorus and can be deposited by PECVD, sputtering or electron beam deposition. Another approach would be to deposit layers of heavily doped silicon nanoparticles in selective regions using inkjet printing, aerosol jet, screen printing or some other suitable deposition technique. In this case, the ink or paste could be a suspension of silicon nanoparticles in an appropriate solvent. The silicon nanoparticles could be heavily doped or another material containing the dopant atoms could be added to the ink or paste. The doped silicon nanoparticles may contain n-type dopants such as phosphorus, arsenic, antimony or bismuth, or p-type dopants such as boron, aluminum, gallium or indium. The dopant concentration in the nanoparticles would typically be in the range of about 0.05 to 5.0 at. %. Another option is to use organometallic inks or pastes containing materials such as silicon chelates and dopant compounds as well as a binder and/or a stabilizer.

By laser firing heavily doped silicon through a dielectric, such as SiNₓ:H, to form localized p⁺ and n⁺ contacts, high quality laser-fired contacts can be formed without causing significant laser-induced damage. Unlike the situation with aluminum laser-fired contacts where most of the incident light is initially reflected, the intense laser light can immediately penetrate into the silicon wafer during the laser doping of heavily doped silicon contacts. The diffusion of dopants such as phosphorus and boron may be increased under intense illumination, as occurs with hydrogen in silicon, which may allow the increased penetration (∼several microns) of phosphorous into silicon. Thus, light-enhanced diffusion may cause the dopants and hydrogen to diffuse beyond the laser-damaged region and create a high quality junction or contact. Moreover, in the case of laser-firing heavily doped silicon contacts through a SiO₂ or SiNₓ dielectric, there are no other foreign atoms introduced into the silicon wafer other than the dopant and either oxygen or nitrogen from the dielectric layer. Additionally, local stresses are reduced since the heavily doped silicon has similar mechanical properties (expansion coefficient, thermal conductivity, etc.) to the silicon wafer.

As a further example, a photovoltaic cell may be formed by (1) first applying a high quality passivation layer (e.g. SiNₓ) to both sides of a wafer; (2) inkjet printing an interdigitated array of silicon dots on a rear surface with one dot pattern containing a silicon ink heavily doped with boron and another dot pattern containing a silicon ink heavily doped with phosphorous; (3) laser firing both dot patterns to form localized n⁺ and p⁺ contacts; (4) inkjet printing interdigitated silver fingers such that one finger pattern overlies the n⁺ contacts and the other finger pattern overlies the p⁺ contacts; and then (5) annealing the contacts.

In certain embodiments, an isolation gap or isolation ring may be formed around the laser-processed base contacts using a base doping ink that is insulating, as described above with respect to FIG. 16. In this instance, an isolation gap may be desirable for preventing shunting of the induced emitter to the base laser-fired contacts. Similar to the embodiments described above and illustrated in FIGS. 3A-3E, the formation of the isolation gap is illustrated in FIG. 22. In FIG. 22, an inversion layer 102 can be induced at the rear of a n-type silicon wafer 100 by using aluminum oxide 104 (with a large fixed negative charge) at the rear of the n-type silicon wafer 100. In particular, a doping layer 106 is deposited as a plurality of dots of a n+ doped silicon ink to form base contacts 108, then a PECVD oxide SiOₓ layer 110 is deposited on top of the aluminum oxide passivation layer 104, and then a plurality of dots of p+ silicon doping ink (or paste) 112 is deposited on a surface of the wafer 100 opposite the surface on which the n+ silicon ink 106 is deposited, to form emitter contacts 114. The isolation gap 116 (where there is no induced inversion layer) is then formed at a border region of the n+ doped silicon ink (or paste) 106 upon firing the contacts with the laser 118.

Alternatively, an isolation gap may be formed by etching or laser ablating the appropriate layers to prevent the formation of an induced emitter or inversion layer. In the case of an inversion layer created by aluminum oxide in n-type silicon, one would locally ablate the aluminum oxide around the laser-processed base contacts. The local ablation could be produced using a picosecond or femtosecond laser operating in the UV or in the green wavelength region.

Laser ablation can also be used to remove metal layers such as silver, copper or aluminum in fabricating a back-contact solar cell. For example, a back-contact cell can be fabricated by depositing suitable dielectric passivation layers on both the front and rear surfaces of a wafer. Then a plurality of dots of p+ silicon doping ink (or paste) and a plurality of dots of n+ doping ink (or paste) are deposited on the rear surface. Laser processing is then used to form localized n+ and p+ regions on the rear surface. A metal film (for example 2 microns of silver) is then deposited over the entire rear surface and a laser is used to define an interdigitated finger pattern by ablating a thin region between the fingers. After the ablation step, one finger pattern contacts the localized n+ regions and the other finger pattern contacts the localized p+ regions. Additional metal would be deposited on the edges to form current carrying busbars. As mentioned above, the metal ablation could be produced using a picosecond or femtosecond laser operating in the UV to IR wavelength region.

The sheet resistance of the induced emitter should be lower (more conductive) in p-type silicon since the mobility of electrons is ∼3x that of holes. The conductance of the induced emitter for a -Si:H i-n+ or i-p+ contacts may be increased by increasing the thickness of the doped a-Si:H layers or by maximizing the fixed negative charge in an aluminum oxide layer.

A thin layer of passivating material that eliminates or passivates surface defect states (such as a-Si:H, SiO₂ or quinhydrone) may be first deposited on the surface of the silicon before depositing dielectric films with a large density of fixed charge. The passivation layer may include any suitable electrically insulating material or dielectric material that assures low surface recombination. Other examples of suitable passivation layers or dielectric passivation layers include silicon carbide, silicon oxynitride or silicon nitride, which can be formed by methods known in the art such as, for example, plasma enhanced chemical vapor deposition (PECVD), low pressure chemical vapor deposition (LPCVD), magnetron sputtering, thermal oxidation, screen printing of pastes, inks or sol gel, and the like. However, the best passivation layers are typically produced by PECVD or in the case of aluminum oxide by ALD (Atomic Layer Deposition) or plasma-assisted ALD. Combinations of two or more of such layers can also be used to form the passivation layer or dielectric passivation layer such as a layer of silicon nitride and a layer of silicon dioxide. When more than one layer is used, at least one of the layers is, preferably, a passivation layer comprising, for example, silicon nitride. Preferably, the passivation layer comprises a layer of silicon nitride formed directly on the surface of the wafer by a method such as PECVD so that the silicon nitride contains hydrogen. Combinations of two or more layers can be chosen so that the combined layers reduce the reflection of light in the wavelength range of 350 to 1100 nanometers (nm) from the front surface, and the first layer deposited on the silicon surface acts as a passivation layer. Gradients between the passivation layers are within the scope of this invention, such as changing a composition with respect to a depth instead of discrete layers and/or boundaries. The total of all such layers used can be up to about 120 nm in thickness, for example about 70 to about 100 nm in thickness. Hydrogenated silicon nitride can be deposited at temperatures of about 200 degrees C to about 450 degrees C, for example, about 350 degrees C to about 400 degrees C, using PECVD in an atmosphere of silane and ammonia.

In certain embodiments, one or more dielectric layers containing large densities of fixed charge can be used to act both as passivation layers and charge screening layers. More particularly, these dielectric layers provide a conductive path to bleed off accumulated charge, as well as providing a highly charged surface layer that screens the semiconductor from the accumulated charge in the vicinity of the surface. In back-contact silicon solar cells, for example, these layers may also act as antireflection layers. For example, aluminum oxide (Al₂O₃) films can possess a negative charge density of ∼ 10¹³ cm⁻³ when deposited by atomic layer deposition (ALD) on silicon or silica while silicon nitride (SiNₓ) films can exhibit a positive charge density of ∼ 10¹² cm⁻³ when deposited on silicon by PECVD. Aluminum oxide films with large fixed negative charge densities can also be grown using PECVD, magnetron sputtering and solution chemistry (sol-gels). When applied as a passivation layer or dielectric passivation layer, these films can be used to create accumulation layers (in p-type silicon using Al₂O₃ or in n-type silicon using SiNₓ) or inversion layers (in n-type silicon using Al₂O₃ or in p-type silicon using SiNₓ). As another example, a bilayer of Al₂O₃/TiO₂ may be applied as a passivation layer or dielectric passivation layer that also acts as an antireflection structure. The thicknesses of the Al₂O₃ (refractive index ≈ 1.77) and TiO₂ (refractive index ≈ 2.5) are chosen to minimize reflection when the solar cells are encapsulated in a material such as EVA. It may also be possible to enhance the fixed negative charge in dielectric films by constructing superlattices (thin alternating layers) of Al₂O₃ and TiO₂ or Al₂O₃ and SiO₂ or Al₂O₃ and SiₓTi₁₋ₓO₂. In addition, the antireflection layer may contain a graded composition of aluminum and titanium oxide where the composition is graded so that the refractive index varies from ∼ 1.77 on the outer surface to ∼2.5 next to the silicon surface.

Another option is to spray or screen print an aluminum ink or paste on aluminum oxide before laser firing. Since aluminum melts at 660 degrees C and boils at ∼2465 degrees C, and aluminum oxide melts at ∼2015 degrees C and boils at 2980 degrees C, the laser-contacting process would have to be a splatter-type laser-fired contact.

Some dielectrics such as aluminum oxide, aluminum nitride, and boron nitride could supply dopants for laser-fired contacts. Also, for PECVD dielectrics one could add other gases to provide atoms that could provide dopants; for example, one could add boron as a dopant to silicon nitride films (forming e.g. SiₓB_{y}N_{z}:H films) by adding B₂H₆ to a plasma atmosphere containing SiH₄ and NH₃. Similarly, one could add aluminum as a dopant to silicon oxide films (forming e.g. SiₓAl_{y}O_{z}:H films) by adding Al(CH₃)₃ to a plasma atmosphere containing SiH₄ and N₂O (the amount of nitrogen incorporated into the films in this case is generally negligible).

The electrical contact layer or layers may comprise a metal, or a metal containing another metal. For example, the metal can be tin, which is isoelectronic with silicon, or tin alloyed with phosphorus, arsenic, antimony, bismuth or a combination thereof. If tin is used and, for example, it is alloyed with an element such as antimony, the amount of such alloy element can be about 0.1 to about 20 atomic percent. As another example, the metal can be aluminum or silver. The electrical contact layer can be deposited initially as a layer by any suitable means, such as, for example, sputtering a suitable target using a magnetron sputtering apparatus or by screen printing a suitable metal paste. Such electrical contacts preferably comprise point contacts, and more preferably point contacts that are formed by a laser firing or laser doping process. The electrical contact layer or layers can have a thickness of about 0.5 to about 30.0 microns, preferably, about 2.0 to about 5.0 microns. Preferably, the thickness of the metal layers is selected to eliminate any significant series resistance in the photovoltaic cell.

The photovoltaic cells of this invention have high efficiency in converting light energy into electrical energy. In particular, the photovoltaic cells include a semiconductor wafer comprising silicon, the wafer having a first light-receiving surface and a second surface opposite the first surface; a passivation layer and a dielectric layer, or a dielectric passivation layer, positioned over at least one of the first and second surfaces of the wafer; a doping layer deposited on a region of at least one of the first and second surfaces of the wafer; an electrical contact layer comprising a metal positioned over at least the dielectric layer or the dielectric passivation layer in the region containing the doping layer; and a plurality of localized base and/or emitter contacts on at least one surface of the wafer in the region containing the doping layer. A number of various embodiments of the cells are illustrated in FIGS. 2, 4, 6, 8, 10, and 12. The photovoltaic cells of this invention can be used to form modules where, for example, a plurality of such cells are electrically connected in a desired arrangement and mounted on or between a suitable supporting substrate such as a section of glass or other suitable material. Methods for making modules from photovoltaic cells are well known to those of skill in the art.

It is to be understood that only certain embodiments of the invention have been described and set forth herein. Alternative embodiments and various modifications will be apparent from the above description to those of skill in the art. These and other alternatives are considered equivalents and within the spirit and scope of the invention.

The present invention may also be defined by way of the following numbered clauses:
1. A method for manufacturing a photovoltaic cell comprising a semiconductor wafer comprising silicon, a first surface and a second surface opposite the first surface, the method comprising:
   depositing a passivation layer and a dielectric layer, or a dielectric passivation layer, on at least one of the first and second surfaces of the wafer;
   depositing a doping layer on a region of at least one of the first and second surfaces of the wafer;
   depositing an electrical contact layer comprising a metal over at least the dielectric layer or the dielectric passivation layer in the region containing the doping layer; and
   splitting a single high-energy laser beam from a laser into an array of laser beams and directing the laser beams at the surface of the wafer in the region containing the doping layer to form localized base and/or emitter contacts on at least one surface of the wafer.
2. The method of clause 1, comprising using at least one optical component selected from the group consisting of diffractive optics, microlenses, spatial light modulators such as micromirror arrays or aperture stop arrays, and combinations thereof, to split the single high-energy laser beam into the array of laser beams.
3. The method of clause 1 or clause 2, further comprising using a tophat laser beam shaper to change a beam profile of the laser from Gaussian to uniform.
4. The method of any one of the preceding clauses, further comprising treating at least one surface of the wafer with localized annealing prior to directing the array of laser beams at the surface of the wafer.
5. The method of any one of the preceding clauses, comprising controlling the array of laser beams to produce an array of laser-doped or laser-fired regions each having a diameter of less than about 20 microns.
6. The method of any one of the preceding clauses, comprising controlling the array of laser beams to produce an array of laser-doped or laser-fired regions each having a line shape with a width of less than about 20 microns and a length greater than about 40 microns.
7. The method of any one of the preceding clauses, wherein the passivation layer or dielectric passivation layer on at least one of the first and second surfaces of the wafer comprises aluminum oxide.
8. The method of any one of the preceding clauses, wherein the doping layer comprises a plurality of doped silicon nanoparticles.
9. The method of any one of the preceding clauses, comprising the following sequence of steps:
   depositing the dielectric passivation layer on at least one of the first and second surfaces of the wafer;
   depositing the doping layer on a region of at least one of the first and second surfaces of the wafer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
10. The method of any one of clauses 1 to 8, comprising the following sequence of steps:
   depositing the doping layer on a region of at least one of the first and second surfaces of the wafer;
   depositing the dielectric passivation layer on at least one of the first and second surfaces of the wafer including the surface containing the doping layer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
11. The method of clause 10, comprising:
   depositing the doping layer as a plurality of dots of a n+ doped silicon ink or paste to form base contacts in an n-type silicon wafer;
   forming a shallow emitter or induced emitter over most of the same surface of the wafer on which the n+ doped silicon ink or paste has been deposited;
   depositing a plurality of dots of p+ silicon ink or paste on the surface of the wafer containing the shallow or induced emitter on which the n+ silicon ink is deposited, to form localized emitter contacts to the shallow or induced emitter in the n-type silicon wafer; and
   forming an isolation gap at a border region of the n+ doped silicon ink upon laser firing the contacts.
12. The method of clause 11, comprising forming the isolation gap around the base contacts using laser ablation.
13. The method of any one of clauses 1 to 8, comprising the following sequence of steps:
   depositing the dielectric passivation layer on at least one of the first and second surfaces of the wafer;
   depositing the doping layer on a region of at least one of the first and second surfaces of the wafer;
   depositing the electrical contact layer comprising the metal over at least the dielectric passivation layer in the region containing the doping layer; and
   splitting the single high-energy laser beam from the laser into an array of laser beams and directing the laser beams at the surface of the wafer in the region containing the doping layer.
14. The method of any one of clauses 1 to 8, comprising the following sequence of steps:
   depositing the doping layer on a region of at least one of the first and second surfaces of the wafer;
   depositing the dielectric passivation layer on at least one of the first and second surfaces of the wafer including the surface containing the doping layer;
   depositing the electrical contact layer comprising the metal over at least the dielectric passivation layer in the region containing the doping layer; and
   splitting the single high-energy laser beam from the laser into an array of laser beams and directing the laser beams at the surface of the wafer in the region containing the doping layer.
15. The method of any one of clauses 1 to 8, comprising the following sequence of steps:
   depositing the passivation layer on at least one of the first and second surfaces of the wafer;
   depositing the doping layer on a region of at least one of the first and second surfaces of the wafer;
   depositing the dielectric layer on at least one of the first and second surfaces of the wafer including the surface containing the doping layer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
16. The method of any one of clauses 1 to 8, comprising the following sequence of steps:
   depositing the passivation layer on at least one of the first and second surfaces of the wafer;
   depositing the doping layer on a region of at least one of the first and second surfaces of the wafer;
   depositing the dielectric layer on at least one of the first and second surfaces of the wafer including the surface containing the doping layer;
   depositing the electrical contact layer comprising the metal over at least the dielectric passivation layer in the region containing the doping layer; and
   splitting the single high-energy laser beam from the laser into an array of laser beams and directing the laser beams at the surface of the wafer in the region containing the doping layer
17. The method of any one of the preceding clauses, further comprising depositing a second electrical contact layer comprising a metal over the region that has been laser-processed.
18. The method of any one of the preceding clauses, further comprising annealing the photovoltaic cell after carrying out all other recited steps.
19. The method of clause 18, wherein the annealing temperature is in a range of 250 degrees Celsius to 700 degrees Celsius and the annealing time is in a range of about 1 second to about 30 minutes.
20. A method for manufacturing a photovoltaic cell comprising a semiconductor wafer comprising silicon, a first surface and a second surface opposite the first surface, the method comprising:
   depositing a passivation layer and a dielectric layer, or a dielectric passivation layer, on at least one of the first and second surfaces of the wafer;
   depositing a doping layer on a region of at least one of the first and second surfaces of the wafer;
   depositing an electrical contact layer comprising a metal over at least the dielectric layer or the dielectric passivation layer in the region containing the doping layer; and
   directing a laser at the surface of the wafer to form localized base and/or emitter contacts on at least the first surface of the wafer in the region containing the doping layer, and controlling the laser beam power density as a function of time.
21. The method of clause 20, comprising controlling the laser beam power density as a function of time and heating the metal in the electrical contact material to a temperature that melts the underlying dielectric layer or dielectric passivation layer without ablating the metal.
22. The method of clause 20 or clause 21, comprising controlling the laser beam power density as a function of time by using gated continuous wave laser pulses, wherein the gated continuous wave laser pulses contain a first pulse that melts and ablates the metal in the electrical contact layer, the passivation layer or dielectric passivation layer, and the first surface of the silicon wafer, followed by a low-energy tail of relatively long duration.
23. The method of any one of clauses 20 to 22, comprising controlling the laser beam power density as a function of time and using a line-shaped laser beam during formation of a laser-processed contact and subsequent hydrogenation or rapid thermal processing at a temperature below about 700 degrees Celsius.
24. The method of any one of clauses 20 to 23, further comprising treating the surface of the wafer with localized annealing prior to directing the laser at the surface of the wafer.
25. The method of any one of clauses 20 to 24, further comprising using a tophat laser beam shaper to change a beam profile of the laser from Gaussian to uniform.
26. The method of any one of clauses 20 to 25, wherein the passivation layer or dielectric passivation layer on at least one of the first and second surfaces of the wafer comprises aluminum oxide.
27. The method of any one of clauses 20 to 26, wherein the doping layer comprises a plurality of doped silicon nanoparticles.
28. The method of any one of clauses 20 to 27, comprising the following sequence of steps:
   depositing the dielectric passivation layer on at least one of the first and second surfaces of the wafer;
   depositing the doping layer on a region of at least one of the first and second surfaces of the wafer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
29. The method of any one of clauses 20 to 27, comprising the following sequence of steps:
   depositing the doping layer on a region of at least one of the first and second surfaces of the wafer;
   depositing the dielectric passivation layer on at least one of the first and second surfaces of the wafer including the surface containing the doping layer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
30. The method of any one of clauses 20 to 27, comprising the following sequence of steps:
   depositing the dielectric passivation layer on at least one of the first and second surfaces of the wafer;
   depositing the doping layer on a region of at least one of the first and second surfaces of the wafer;
   depositing the electrical contact layer comprising the metal over at least the dielectric passivation layer in the region containing the doping layer; and
   splitting the single high-energy laser beam from the laser into an array of laser beams and directing the laser beams at the first of the wafer in the region containing the doping layer.
31. The method of any one of clauses 20 to 27, comprising the following sequence of steps:
   depositing the doping layer on a region of at least one of the first and second surfaces of the wafer;
   depositing the dielectric passivation layer on at least one of the first and second surfaces of the wafer including the surface containing the doping layer;
   depositing the electrical contact layer comprising the metal over at least the dielectric passivation layer in the region containing the doping layer; and
   splitting the single high-energy laser beam from the laser into an array of laser beams and directing the laser beams at the surface of the wafer in the region containing the doping layer.
32. The method of any one of clauses 20 to 27, comprising the following sequence of steps:
   depositing the passivation layer on at least one of the first and second surfaces of the wafer;
   depositing the doping layer on a region of at least one of the first and second surfaces of the wafer;
   depositing the dielectric layer on at least one of the first and second surfaces of the wafer including the surface containing the doping layer;
   splitting the single high-energy laser beam from the laser into an array of laser beams and directing the laser beams at the surface of the wafer in the region containing the doping layer; and
   depositing the electrical contact layer comprising the metal over at least the dielectric passivation layer in the region that was exposed to the laser beams.
33. The method of any one of clauses 20 to 27, comprising the following sequence of steps:
   depositing the passivation layer on at least one of the first and second surfaces of the wafer;
   depositing the doping layer on a region of at least one of the first and second surfaces of the wafer;
   depositing the dielectric layer on at least one of the first and second surfaces of the wafer including the surface containing the doping layer;
   depositing the electrical contact layer comprising the metal over at least the dielectric passivation layer in the region containing the doping layer; and
   splitting the single high-energy laser beam from the laser into an array of laser beams and directing the laser beams at the surface of the wafer in the region containing the doping layer
34. The method of any one of clauses 20 to 33, further comprising depositing a second electrical contact layer comprising a metal over the region that has been laser-processed.
35. The method of any one of clauses 20 to 34, further comprising annealing the photovoltaic cell after carrying out all other recited steps.
36. The method of clause 35, wherein the annealing temperature is in a range of 250 degrees Celsius to 700 degrees Celsius and the annealing time is in a range of about 1 second to about 30 minutes.
37. A method for manufacturing a photovoltaic cell comprising a semiconductor wafer comprising silicon, a first surface and a second surface opposite the first surface, the method comprising:
   depositing a passivation layer and a dielectric layer, or a dielectric passivation layer, on at least one of the first and second surfaces of the wafer;
   depositing a doping layer on a region of at least one of the first and second surfaces of the wafer;
   depositing an electrical contact layer comprising a metal over at least the dielectric layer or the dielectric passivation layer in the region containing the doping layer; and
   splitting a single high-energy laser beam from a laser into an array of laser beams and directing the laser beams at the surface of the wafer in the region containing the doping layer to form localized base and/or emitter contacts on at least the surface of the wafer, and controlling the laser beam power density as a function of time.
38. A method for forming an electrical contact between an electrical conducting layer and a second layer, where there is at least a third layer positioned between the electrical conducting layer and the second layer, the method comprising:
   depositing a passivation layer and a dielectric layer, or a dielectric passivation layer, on at least one surface of the third layer;
   depositing a doping layer on a region of at least one surface of the third layer;
   depositing the electrical conducting layer over at least the dielectric layer or the dielectric passivation layer in the region containing the doping layer; and
   splitting a single high-energy laser beam from a laser into an array of laser beams and directing the laser beams at the surface of the third layer in the region containing the doping layer to form localized base and/or emitter contacts on at least the surface of the third layer, and controlling the laser beam power density as a function of time.
39. A photovoltaic cell comprising:
   a semiconductor wafer comprising silicon, the wafer having a first surface and a second light-receiving surface opposite the first surface;
   a passivation layer and a dielectric layer, or a dielectric passivation layer, positioned over at least one of the first and second surfaces of the wafer;
   a doping layer deposited on a region of at least one of the first and second surfaces of the wafer;
   an electrical contact layer comprising a metal positioned over at least the dielectric layer or the dielectric passivation layer in the region containing the doping layer; and
   a plurality of localized base and/or emitter contacts on at least one surface of the wafer in the region containing the doping layer.
40. A method for manufacturing a photovoltaic cell comprising a semiconductor wafer comprising silicon, a first surface and a second surface opposite the first surface, the method comprising:
   depositing both localized n+ and p+ contacts on a rear surface of the silicon wafer;
   depositing at least one antireflection layer on a front surface of the silicon wafer, wherein at least one antireflection layer contains a large density of fixed charges.
41. The method of clause 40, wherein at least one antireflection layer comprises aluminum oxide, and the layer contains a large negative fixed charge.
42. The method of clause 40 or clause 41, further comprising forming a shallow or induced emitter over most of the rear surface of the silicon wafer.
43. The method of any one of clauses 40 to 42, wherein the at least one antireflection layer comprises thin alternating layers of aluminum oxide and silicon oxide, or thin alternating layers of aluminum oxide and titanium oxide.
44. A method for manufacturing a photovoltaic cell comprising a semiconductor wafer comprising silicon, a first surface and a second surface opposite the first surface, the method comprising:
   depositing both localized n+ and p+ contacts on a rear surface of the silicon wafer; and
   using laser ablation to define an interdigitated finger pattern on the rear surface of the silicon wafer.

## Claims

1. A method for manufacturing a photovoltaic cell comprising a semiconductor wafer comprising silicon, a first surface and a second surface opposite the first surface, the method comprising:
depositing a passivation layer and a dielectric layer, or a dielectric passivation layer, on at least one of the first and second surfaces of the wafer;
depositing a doping layer on a region of at least one of the first and second surfaces of the wafer;
depositing an electrical contact layer comprising a metal over at least the dielectric layer or the dielectric passivation layer in the region containing the doping layer; and
splitting a single high-energy laser beam from a laser into an array of laser beams and directing the laser beams at the surface of the wafer in the region containing the doping layer to form localized base and/or emitter contacts on at least one surface of the wafer.

2. The method of claim 1, comprising using at least one optical component selected from the group consisting of diffractive optics, microlenses, spatial light modulators such as micromirror arrays or aperture stop arrays, and combinations thereof, to split the single high-energy laser beam into the array of laser beams.

3. The method of claim 1, further comprising using a tophat laser beam shaper to change a beam profile of the laser from Gaussian to uniform.

4. The method of claim 1, further comprising treating at least one surface of the wafer with localized annealing prior to directing the array of laser beams at the surface of the wafer.

5. The method of claim 1, comprising controlling the array of laser beams to produce an array of laser-doped or laser-fired regions each having a diameter of less than about 20 microns.

6. The method of claim 1, comprising controlling the array of laser beams to produce an array of laser-doped or laser-fired regions each having a line shape with a width of less than about 20 microns and a length greater than about 40 microns.

7. The method of claim 1, wherein the doping layer comprises a plurality of doped silicon nanoparticles.

8. The method of claim 1, comprising the following sequence of steps:
depositing the dielectric passivation layer on at least one of the first and second surfaces of the wafer;
depositing the doping layer on a region of at least one of the first and second surfaces of the wafer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

9. The method of claim 1, comprising the following sequence of steps:
depositing the doping layer on a region of at least one of the first and second surfaces of the wafer;
depositing the dielectric passivation layer on at least one of the first and second surfaces of the wafer including the surface containing the doping layer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

10. The method of claim 9, comprising:
depositing the doping layer as a plurality of dots of a n+ doped silicon ink or paste to form base contacts in an n-type silicon wafer;
forming a shallow emitter or induced emitter over most of the same surface of the wafer on which the n+ doped silicon ink or paste has been deposited;
depositing a plurality of dots of p+ silicon ink or paste on the surface of the wafer containing the shallow or induced emitter on which the n+ silicon ink is deposited, to form localized emitter contacts to the shallow or induced emitter in the n-type silicon wafer; and
forming an isolation gap at a border region of the n+ doped silicon ink upon laser firing the contacts.

11. The method of claim 10, comprising forming the isolation gap around the base contacts using laser ablation.

12. The method of claim 1, comprising the following sequence of steps:
depositing the dielectric passivation layer on at least one of the first and second surfaces of the wafer;
depositing the doping layer on a region of at least one of the first and second surfaces of the wafer;
depositing the electrical contact layer comprising the metal over at least the dielectric passivation layer in the region containing the doping layer; and
splitting the single high-energy laser beam from the laser into an array of laser beams and directing the laser beams at the surface of the wafer in the region containing the doping layer.

13. The method of claim 1, comprising the following sequence of steps:
depositing the doping layer on a region of at least one of the first and second surfaces of the wafer;
depositing the dielectric passivation layer on at least one of the first and second surfaces of the wafer including the surface containing the doping layer;
depositing the electrical contact layer comprising the metal over at least the dielectric passivation layer in the region containing the doping layer; and
splitting the single high-energy laser beam from the laser into an array of laser beams and directing the laser beams at the surface of the wafer in the region containing the doping layer.

14. The method of claim 1, comprising the following sequence of steps:
depositing the passivation layer on at least one of the first and second surfaces of the wafer;
depositing the doping layer on a region of at least one of the first and second surfaces of the wafer;
depositing the dielectric layer on at least one of the first and second surfaces of the wafer including the surface containing the doping layer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

15. The method of claim 1, comprising the following sequence of steps:
depositing the passivation layer on at least one of the first and second surfaces of the wafer;
depositing the doping layer on a region of at least one of the first and second surfaces of the wafer;
depositing the dielectric layer on at least one of the first and second surfaces of the wafer including the surface containing the doping layer;
depositing the electrical contact layer comprising the metal over at least the dielectric passivation layer in the region containing the doping layer; and
splitting the single high-energy laser beam from the laser into an array of laser beams and directing the laser beams at the surface of the wafer in the region containing the doping layer

16. The method of claim 1, further comprising depositing a second electrical contact layer comprising a metal over the region that has been laser-processed.

17. The method of claim 1, further comprising annealing the photovoltaic cell after carrying out all other recited steps.

18. The method of claim 17, wherein the annealing temperature is in a range of 250 degrees Celsius to 700 degrees Celsius and the annealing time is in a range of about 1 second to about 30 minutes.

19. A method for manufacturing a photovoltaic cell comprising a semiconductor wafer comprising silicon, a first surface and a second surface opposite the first surface, the method comprising:
depositing a passivation layer and a dielectric layer, or a dielectric passivation layer, on at least one of the first and second surfaces of the wafer;
depositing a doping layer on a region of at least one of the first and second surfaces of the wafer;
depositing an electrical contact layer comprising a metal over at least the dielectric layer or the dielectric passivation layer in the region containing the doping layer; and
directing a laser at the surface of the wafer to form localized base and/or emitter contacts on at least the first surface of the wafer in the region containing the doping layer, and controlling the laser beam power density as a function of time.

20. The method of claim 19, comprising controlling the laser beam power density as a function of time and heating the metal in the electrical contact material to a temperature that melts the underlying dielectric layer or dielectric passivation layer without ablating the metal.

21. The method of claim 19, comprising controlling the laser beam power density as a function of time by using gated continuous wave laser pulses, wherein the gated continuous wave laser pulses contain a first pulse that melts and ablates the metal in the electrical contact layer, the passivation layer or dielectric passivation layer, and the first surface of the silicon wafer, followed by a low-energy tail of relatively long duration.

22. The method of claim 19, comprising controlling the laser beam power density as a function of time and using a line-shaped laser beam during formation of a laser-processed contact and subsequent hydrogenation or rapid thermal processing at a temperature below about 700 degrees Celsius.

23. The method of claim 19, further comprising treating the surface of the wafer with localized annealing prior to directing the laser at the surface of the wafer.

24. The method of claim 19, further comprising using a tophat laser beam shaper to change a beam profile of the laser from Gaussian to uniform.

25. The method of claim 19, wherein the doping layer comprises a plurality of doped silicon nanoparticles.

26. The method of claim 19, comprising the following sequence of steps:
depositing the dielectric passivation layer on at least one of the first and second surfaces of the wafer;
depositing the doping layer on a region of at least one of the first and second surfaces of the wafer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

27. The method of claim 19, comprising the following sequence of steps:
depositing the doping layer on a region of at least one of the first and second surfaces of the wafer;
depositing the dielectric passivation layer on at least one of the first and second surfaces of the wafer including the surface containing the doping layer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

28. The method of claim 19, comprising the following sequence of steps:
depositing the dielectric passivation layer on at least one of the first and second surfaces of the wafer;
depositing the doping layer on a region of at least one of the first and second surfaces of the wafer;
depositing the electrical contact layer comprising the metal over at least the dielectric passivation layer in the region containing the doping layer; and
splitting the single high-energy laser beam from the laser into an array of laser beams and directing the laser beams at the first of the wafer in the region containing the doping layer.

29. The method of claim 19, comprising the following sequence of steps:
depositing the doping layer on a region of at least one of the first and second surfaces of the wafer;
depositing the dielectric passivation layer on at least one of the first and second surfaces of the wafer including the surface containing the doping layer;
depositing the electrical contact layer comprising the metal over at least the dielectric passivation layer in the region containing the doping layer; and
splitting the single high-energy laser beam from the laser into an array of laser beams and directing the laser beams at the surface of the wafer in the region containing the doping layer.

30. The method of claim 19, comprising the following sequence of steps:
depositing the passivation layer on at least one of the first and second surfaces of the wafer;
depositing the doping layer on a region of at least one of the first and second surfaces of the wafer;
depositing the dielectric layer on at least one of the first and second surfaces of the wafer including the surface containing the doping layer;
splitting the single high-energy laser beam from the laser into an array of laser beams and directing the laser beams at the surface of the wafer in the region containing the doping layer; and
depositing the electrical contact layer comprising the metal over at least the dielectric passivation layer in the region that was exposed to the laser beams.

31. The method of claim 19, comprising the following sequence of steps:
depositing the passivation layer on at least one of the first and second surfaces of the wafer;
depositing the doping layer on a region of at least one of the first and second surfaces of the wafer;
depositing the dielectric layer on at least one of the first and second surfaces of the wafer including the surface containing the doping layer;
depositing the electrical contact layer comprising the metal over at least the dielectric passivation layer in the region containing the doping layer; and
splitting the single high-energy laser beam from the laser into an array of laser beams and directing the laser beams at the surface of the wafer in the region containing the doping layer

32. The method of claim 19, further comprising depositing a second electrical contact layer comprising a metal over the region that has been laser-processed.

33. The method of claim 19, further comprising annealing the photovoltaic cell after carrying out all other recited steps.

34. The method of claim 33, wherein the annealing temperature is in a range of 250 degrees Celsius to 700 degrees Celsius and the annealing time is in a range of about 1 second to about 30 minutes.

35. A method for manufacturing a photovoltaic cell comprising a semiconductor wafer comprising silicon, a first surface and a second surface opposite the first surface, the method comprising:
depositing a passivation layer and a dielectric layer, or a dielectric passivation layer, on at least one of the first and second surfaces of the wafer;
depositing a doping layer on a region of at least one of the first and second surfaces of the wafer;
depositing an electrical contact layer comprising a metal over at least the dielectric layer or the dielectric passivation layer in the region containing the doping layer; and
splitting a single high-energy laser beam from a laser into an array of laser beams and directing the laser beams at the surface of the wafer in the region containing the doping layer to form localized base and/or emitter contacts on at least the surface of the wafer, and controlling the laser beam power density as a function of time.

36. A method for forming an electrical contact between an electrical conducting layer and a second layer, where there is at least a third layer positioned between the electrical conducting layer and the second layer, the method comprising:
depositing a passivation layer and a dielectric layer, or a dielectric passivation layer, on at least one surface of the third layer;
depositing a doping layer on a region of at least one surface of the third layer;
depositing the electrical conducting layer over at least the dielectric layer or the dielectric passivation layer in the region containing the doping layer; and
splitting a single high-energy laser beam from a laser into an array of laser beams and directing the laser beams at the surface of the third layer in the region containing the doping layer to form localized base and/or emitter contacts on at least the surface of the third layer, and controlling the laser beam power density as a function of time.

37. A photovoltaic cell comprising:
a semiconductor wafer comprising silicon, the wafer having a first surface and a second light-receiving surface opposite the first surface;
a passivation layer and a dielectric layer, or a dielectric passivation layer, positioned over at least one of the first and second surfaces of the wafer;
a doping layer deposited on a region of at least one of the first and second surfaces of the wafer;
an electrical contact layer comprising a metal positioned over at least the dielectric layer or the dielectric passivation layer in the region containing the doping layer; and
a plurality of localized base and/or emitter contacts on at least one surface of the wafer in the region containing the doping layer.

38. A method for manufacturing a photovoltaic cell comprising a semiconductor wafer comprising silicon, a first surface and a second surface opposite the first surface, the method comprising:
depositing both localized n+ and p+ contacts on a rear surface of the silicon wafer;
depositing at least one antireflection layer on a front surface of the silicon wafer, wherein at least one antireflection layer contains a large density of fixed charges.

39. The method of claim 38, wherein at least one antireflection layer comprises aluminum oxide, and the layer contains a large negative fixed charge.

40. The method of claim 38, further comprising forming a shallow or induced emitter over most of the rear surface of the silicon wafer.

41. The method of claim 38, wherein the at least one antireflection layer comprises thin alternating layers of aluminum oxide and silicon oxide, or thin alternating layers of aluminum oxide and titanium oxide.

42. A method for manufacturing a photovoltaic cell comprising a semiconductor wafer comprising silicon, a first surface and a second surface opposite the first surface, the method comprising:
depositing both localized n+ and p+ contacts on a rear surface of the silicon wafer; and
using laser ablation to define an interdigitated finger pattern on the rear surface of the silicon wafer.
